# EUROPEAN PATENT SPECIFICATION

(11) **EP 4 207 323 B1**
(45) Date of publication and mention of the grant of the patent: **02.12.2026**
(21) Application number: 21905124.0
(22) Date of filing: 30.08.2021
(51) Int. Cl.: H10K 85/60, H10K 50/12, C09K 11/02, C09K 11/06, H10K 85/40

(54) **ORGANIC ELECTROLUMINESCENT DEVICE AND DISPLAY APPARATUS**
ORGANISCHE ELEKTROLUMINESZENTE VORRICHTUNG UND ANZEIGEVORRICHTUNG
DISPOSITIF ÉLECTROLUMINESCENT ORGANIQUE ET APPAREIL D'AFFICHAGE

(30) Priority: 15.12.2020 CN 202011480750
(43) Date of publication of application: 05.07.2023
(73) Proprietor: Kunshan Go-Visionox Opto-Electronics Co., Ltd., KunShan, Jiangsu 215300 (CN)
(72) Inventor: LI, Guomeng, Kunshan, Jiangsu 215300 (CN); ZHANG, Yuewei, Kunshan, Jiangsu 215300 (CN); LI, Mengzhen, Kunshan, Jiangsu 215300 (CN); YAO, Chunliang, Kunshan, Jiangsu 215300 (CN); LIU, Bin, Kunshan, Jiangsu 215300 (CN); XU, Jin, Kunshan, Jiangsu 215300 (CN)
(74) Representative: Kraus & Lederer PartGmbB
(86) International application number: PCT/CN2021/115212
(87) International publication number: WO 2022/127191

(56) References cited:
- CN-A- 111 755 615
- CN-A- 111 864 098
- CN-A- 111 933 811
- CN-A- 112 490 382
- CN-A- 112 614 953
- CN-A- 112 614 954

## Description

### TECHNICAL FIELD

The present application relates to the technical field of organic electroluminescence and, in particular, to an organic electroluminescent device and a display apparatus.

### BACKGROUND

Thermally activated sensitized fluorescence (TASF) means that when a thermally activated delayed fluorescence (TADF) material is used as a sensitizer, the energy of a host material is transferred to the TADF material, and the triplet energy of the TADF material is returned to the singlet through a reverse intersystem crossing (RISC) process, thereby transferring the energy to a doped fluorescent dye to emit light. In this manner, the complete energy transfer from the host material to dye molecules can be achieved so that a traditional fluorescent doped dye can also break through the internal quantum efficiency limit of 25%.

However, in a TASF light-emitting device, there often exists a problem of serious dye carrier capture, and a relatively high drive voltage, serious efficiency roll-off and a relatively short service life of the device.

Therefore, it is urgent to develop a new TASF device in the art, which reduces the drive voltage and improves the device efficiency and the service life. Further relevant technologies are also known from CN111933811A which relates to an organic light-emitting device and a display device, and CN111864098A which relates to an organic light-emitting device and a display device.

### SUMMARY

The present application provides an organic electroluminescent device. The electroluminescent device has a relatively low drive voltage, relatively high device efficiency and a relatively long service life.

The invention is set out in the appended set of claims.

### BRIEF DESCRIPTION OF DRAWINGS

FIG. 1 is a structure diagram of an organic electroluminescent device according to an embodiment and a comparative example of the present application.
FIG. 2 is a graph illustrating a comparison of external quantum efficiency-brightness between devices of embodiment three and comparative example two.
FIG. 3 is a graph illustrating brightness decay of devices of embodiment three and comparative example two at a brightness of 1000 cd/m².

### DETAILED DESCRIPTION

For ease of understanding the present application, embodiments of the present application are listed below. Those skilled in the art are to understand that the embodiments described herein are merely used for understanding the present application and are not to be construed as specific limitations to the present application.

At present, in a TADF electroluminescent device, there often exists a problem of serious dye carrier capture, and a relatively high drive voltage, serious efficiency roll-off and a relatively short service life of the device. Through researches, the inventors have found that one of the main reasons for the above problems is that in an EML of the device, an energy gap of a host material and an energy gap of a sensitizer material are each greater than that of a fluorescent dye, resulting in certain problems of carrier capture and quenching of the fluorescent dye itself.

To solve the problems, the present application provides an organic electroluminescent device. The organic electroluminescent device comprises a first electrode, a second electrode and an organic layer disposed between the first electrode and the second electrode.

The organic layer comprises an EML, the EML comprises a host material, a TADF sensitizer and a fluorescent dye, and the fluorescent dye is selected from a compound represented by Formula (1).

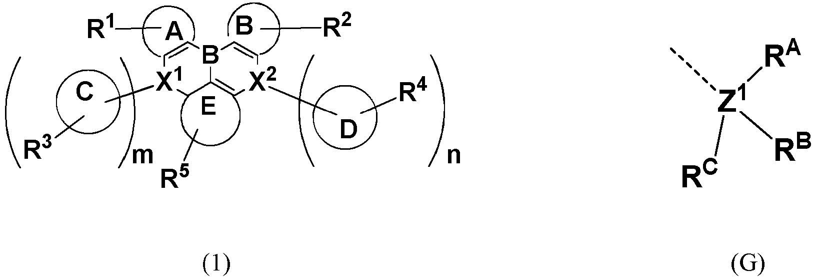

In the above Formula (1), the rings A, B, C, D and E each independently represent an aromatic ring or a heteroaromatic ring, and two adjacent rings are capable of being fused to form a five-membered ring or a six-membered ring containing X¹ or X²; X¹ and X² are each independently selected from one of O, S, N, C or Si; m is 0, 1 or 2, and n is 0, 1 or 2; and R¹, R², R³, R⁴ and R⁵ each independently represent from mono substitution to the maximum permissible substitution and are each independently selected from one or a combination of at least two of hydrogen, C₁ to C₁₀ chain alkyl, C₃ to C₁₀ cycloalkyl, C₁ to C₁₀ alkoxy, halogen, cyano, nitro, hydroxyl, ester, silicyl, amino, substituted or unsubstituted C₆ to C₃₀ arylamino, substituted or unsubstituted C₃ to C₃₀ heteroarylamino, substituted or unsubstituted C₆ to C₃₀ aryl or substituted or unsubstituted C₃ to C₃₀ heteroaryl, and at least one of R¹, R², R³, R⁴ and R⁵ is Formula (G).

In Formula (G), Z¹ is selected from C or Si; R^{A}, R^{B} and R^{C} are each independently selected from one of C₁ to C₁₀ chain alkyl, C₃ to C₁₀ cycloalkyl, substituted or unsubstituted C₆ to C₃₀ aryl or substituted or unsubstituted C₃ to C₃₀ heteroaryl, at least one of R^{A}, R^{B} and R^{C} is substituted or unsubstituted C₆ to C₃₀ aryl or substituted or unsubstituted C₃ to C₃₀ heteroaryl, and at least one of R^{A}, R^{B} and R^{C} is C₁ to C₁₀ chain alkyl or C₃ to C₁₀ cycloalkyl.

When a substituent is present in R^{A}, R^{B} and R^{C}, the substituent is selected from one or a combination of at least two of halogen, cyano, carboxy, C₁ to C₁₂ alkyl, C₃ to C₁₂ cycloalkyl, C₂ to C₁₀ alkenyl, C₁ to C₆ alkoxy or thioalkoxy, C₆ to C₃₀ monocyclic aryl or fused-ring aryl or C₃ to C₃₀ monocyclic heteroaryl or fused-ring heteroaryl.

According to the invention, the fluorescent dye is selected from any one or a combination of at least two of compounds represented by the following Formulas (IV), (V), (VI), (VII) or (VIII): 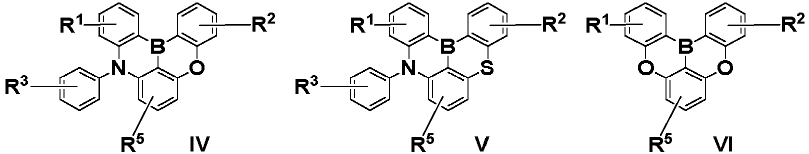 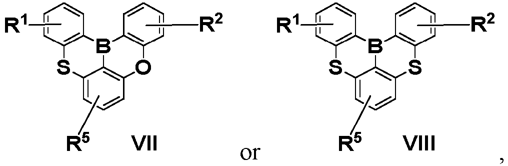 wherein R¹, R², R³ and R⁵ are as defined in the general Formula (1).

In Formula (1), when X¹ is selected from O or S, m is 0; when X² is selected from O or S, n is 0.

It is to be noted that in the present application, the maximum permissible substitution means that the number of substituents is the maximum number of substitutions on the premise that the substituted group satisfies a requirement for chemical bonds.

In the present application, the expression of Ca to Cb represents that the number of carbon atoms in a backbone of the group is a to b, and unless otherwise specified, the number of carbon atoms generally does not comprise the number of carbon atoms in a substituent of the group.

In the present application, the "substituted group" refers to a selection range of substituents when the "substituted or unsubstituted" group is substituted. The number of substituents is not specifically limited, as long as the requirement for compound bonds is satisfied. Exemplarily, the number of substituents may be one, two, three, four or five, and when the number of substituents is two or more, the two or more substituents may be the same or different.

In the present application, the expression of the ring structure crossed by "-" represents that a linkage site is at any position on the ring structure where the bonding can be formed.

In the present application, substituted or unsubstituted C₆ to C₃₀ aryl is preferably C₆ to C₂₀ aryl, more preferably a group selected from the group consisting of phenyl, biphenyl, terphenyl, naphthyl, anthryl, phenanthryl, indenyl, fluorenyl and a derivative thereof, fluoranthenyl, triphenylene, pyrenyl, perylenyl, chrysenyl and naphthacenyl. Specifically, biphenyl is selected from 2-biphenyl, 3-biphenyl and 4-biphenyl; terphenyl comprises p-terphenyl-4-yl, p-terphenyl-3-yl, p-terphenyl-2-yl, m-terphenyl-4-yl, m-terphenyl-3-yl and *m*-terphenyl-2-yl; naphthyl comprises 1-naphthyl and 2-naphthyl; anthryl is selected from 1-anthryl, 2-anthryl and 9-anthryl; fluorenyl is selected from 1-fluorenyl, 2-fluorenyl, 3-fluorenyl, 4-fluorenyl and 9-fluorenyl; the fluorenyl derivative is selected from 9,9'-dimethylfluorene, 9,9'-spirobifluorene and benzofluorene; pyrenyl is selected from 1-pyrenyl, 2-pyrenyl and 4-pyrenyl; and naphthacenyl is selected from 1-naphthacenyl, 2-naphthacenyl and 9-naphthacenyl.

The heteroatom described in the present application generally refers to an atom or an atomic group selected from N, O, S, P, Si and Se, preferably selected from N, O and S. The atomic name described in the present application comprises various isotopes corresponding thereto, for example, hydrogen (H) comprises ¹H (protium or H), ²H (deuterium or D) and the like; and carbon (C) comprises ¹²C, ¹³C and the like.

In the present application, substituted or unsubstituted C₃ to C₃₀ heteroaryl is preferably C₄ to C₂₀ heteroaryl, more preferably nitrogen-containing heteroaryl, oxygen-containing heteroaryl, sulfur-containing heteroaryl or the like, and in a specific example, the substituted or unsubstituted C₃ to C₃₀ heteroaryl comprises furanyl, thienyl, pyrrolyl, benzofuranyl, benzothienyl, isobenzofuranyl, indolyl, dibenzofuranyl, dibenzothienyl and carbazolyl and a derivative thereof, where the carbazolyl derivative is preferably 9-phenylcarbazole, 9-naphthylcarbazolebenzocarbazole, dibenzocarbazole or indolocarbazole.

In the present application, the above C₁ to C₂₀ chain alkyl is preferably C₁ to C₁₀ chain alkyl, more preferably C₁ to C₆ chain alkyl, such as methyl, ethyl, n-propyl, n-butyl, n-hexyl, n-octyl, isopropyl, isobutyl and tert-butyl.

In the present application, C₃ to C₁₂ cycloalkyl comprises monocycloalkyl and polycycloalkyl, preferably C₁ to C₁₀ alkyl and C₃ to C₁₀ cycloalkyl.

The present application provides a new TASF device using the compound represented by Formula (1) as the fluorescent dye. A boron atom contained in the fluorescent dye has a resonance effect with O, S, N, C or Si atoms in the same ring so that the fluorescent dye has characteristics of a narrow spectrum and TADF emission. In addition, the fluorescent dye contains a substitution of a quaternary carbon or quaternary silicon group, and it is ensured that the group has at least one alkyl, so that while the transmission capability is ensured, the molecular spacing can be further increased, the quenching caused by the stacking can be suppressed, the efficiency roll-off can be further reduced, and the device service life can be prolonged. In the present application, the fluorescent dye having the specific structure is used in combination with the host material and the sensitizer to form the EML so that the TASF device can have relatively high efficiency, a relatively long service life and a relatively low drive voltage.

In an optional embodiment, the ring A and the ring C are fused to form a five-membered ring or a six-membered ring containing X¹; or, the ring B and the ring D are fused to form a five-membered ring or a six-membered ring containing X². Alternatively, the ring A and the ring C are fused to form a five-membered ring or a six-membered ring containing X¹, and the ring B and the ring D are fused to form a five-membered ring or a six-membered ring containing X².

In an optional embodiment, the rings A, B, C, D and E are each independently selected from a five to eight-membered aryl ring or a five to eight-membered heteroaryl ring.

In an optional embodiment, the rings A, B, C, D and E are each independently selected from a six-membered aryl ring or a five-membered heteroaryl ring.

In an optional embodiment, the rings A, B, C, D and E are each independently selected from one of substituted or unsubstituted C₆ to C₃₀ aryl or substituted or unsubstituted C₃ to C₃₀ heteroaryl.

In an optional embodiment, the rings A, B, C, D and E are each independently selected from the following substituted or unsubstituted groups: a benzene ring, a furan ring, a thiophene ring, a naphthalene ring, a phenanthrene ring or a carbazole ring.

In the present application, further preferably, a parent nucleus of the fluorescent dye contains two N atoms, which form a B-N resonance structure with a B atom. The fluorescent dye having the structure has the characteristics of a narrower spectrum and more excellent TADF emission and can further improve the performance of the TASF device when used in combination with the host material and the sensitizer.

In an optional embodiment, Formula (G) is the following Formula (G1):

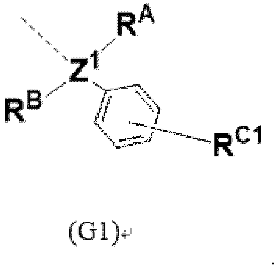

In Formula (G1), at least one of R^{A} or R^{B} is C₁ to C₁₀ chain alkyl or C₃ to C₁₀ cycloalkyl; and R^{C1} is selected from one of hydrogen, C₁ to C₁₀ chain alkyl, C₃ to C₁₀ cycloalkyl, C₁ to C₁₀ alkoxy, substituted or unsubstituted C₆ to C₃₀ arylamino, substituted or unsubstituted C₃ to C₃₀ heteroarylamino, substituted or unsubstituted C₆ to C₃₀ aryl, or substituted or unsubstituted C₃ to C₃₀ heteroaryl.

In the present application, preferably, a substituent in the fluorescent dye contains at least one benzene ring. Such structure has a characteristic of improving steric hindrance and can further improve the performance of the TASF device when used in combination with the host material and the sensitizer.

In an optional embodiment, at least one of R^{A} or R^{B} is selected from methyl, ethyl, n-propyl, isopropyl, n-butyl, isobutyl, sec-butyl, *tert-*butyl, 2-methylbutyl, n-pentyl, *sec*-pentyl, cyclopentyl, neopentyl, n-hexyl, cyclohexyl, neohexyl, n-heptyl, cycloheptyl, n-octyl or cyclooctyl, and R^{C1} is selected from hydrogen, deuterium, methyl, ethyl, n-propyl, isopropyl, n-butyl, isobutyl, sec-butyl, phenyl, naphthyl, anthryl, thienyl, pyrrolyl, indolyl, carbazolyl or pyridyl.

In an optional embodiment, Formula (G) is one of the following Formulas a, b, c or d:

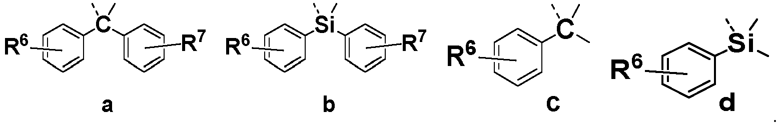

In the above Formulas a, b, c and d, R⁶ and R⁷ are each independently selected from one or a combination of at least two of hydrogen, deuterium, halogen, C₁ to C₁₀ chain alkyl or C₃ to C₁₀ cycloalkyl.

In an optional embodiment, Formula (G) is selected from Formula a or Formula c.

In the present application, further preferably, the fluorescent dye contain an aryl-substituted quaternary carbon group. The fluorescent dye having the structure has a moderate molecular weight and a moderate steric hindrance effect ability, and can further improve the performance of the device when used in combination with the host material and the sensitizer. In addition, the dye is not large in overall molecular weight after introduction, and is easy to evaporate.

In an optional embodiment, R⁶ and R⁷ are each independently selected from hydrogen, or each independently selected from one of the following groups:

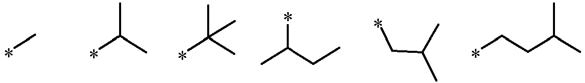

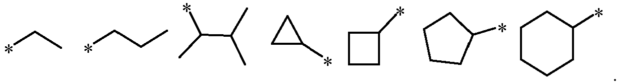

In an optional embodiment, R⁶ and R⁷ are each independently selected from hydrogen.

In an optional embodiment, R¹, R², R³, R⁴ and R⁵ are each independently selected from hydrogen, or each independently selected from one of the following groups:

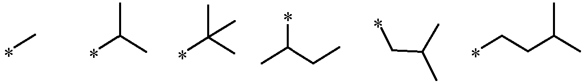

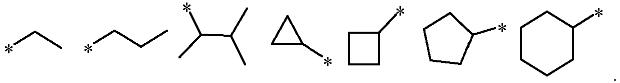

The fluorescent dye described in the present application can be prepared through a conventional method in the art, and the present application merely exemplarily provides the following representative synthesis routes:

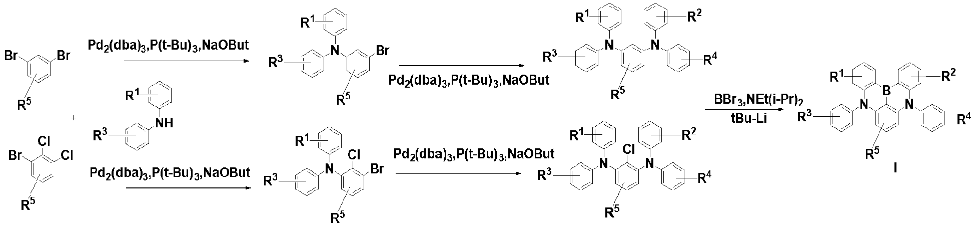

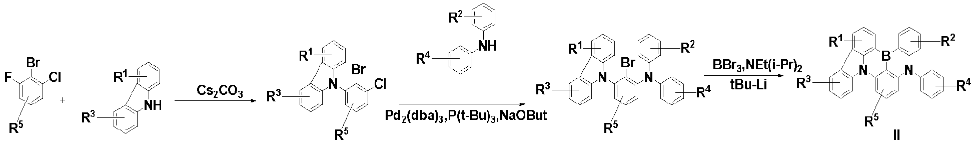

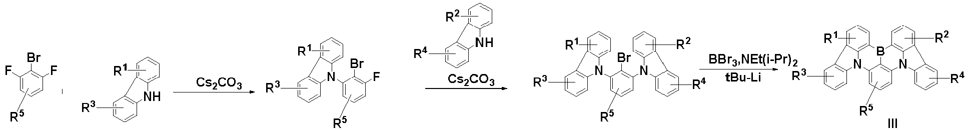

It is to be noted that acquiring the fluorescent dye of the present application is not limited to the synthesis methods and the raw materials used in the present application, and those skilled in the art can also select another method or route to obtain the fluorescent dye provided in the present application.

In an optional embodiment, the host material is selected from any one or a combination of at least two of the following compounds TDH-1 to TDH-30 (such as a combination of TDH-2 and TDH-10, a combination of TDH-23 and TDH-8 or a combination of TDH-16, TDH-22 and TDH-30):

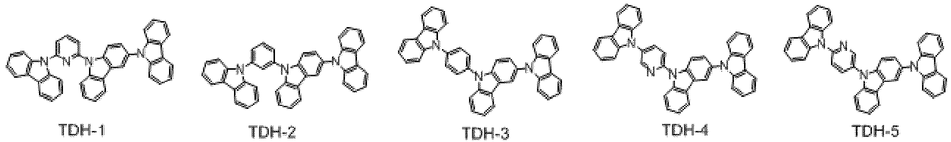

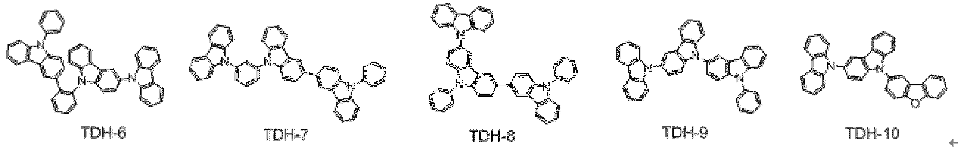

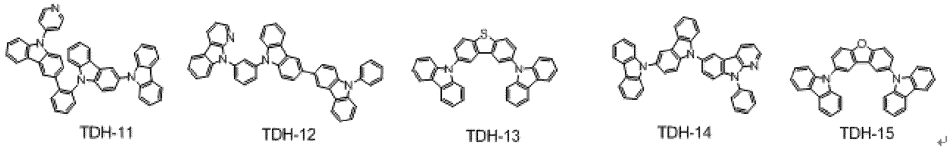

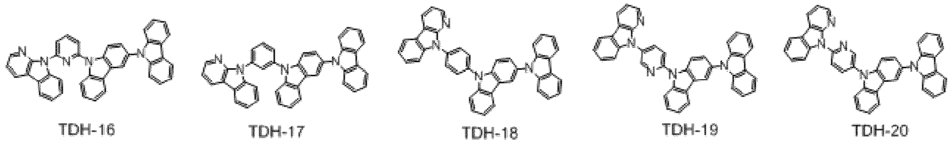

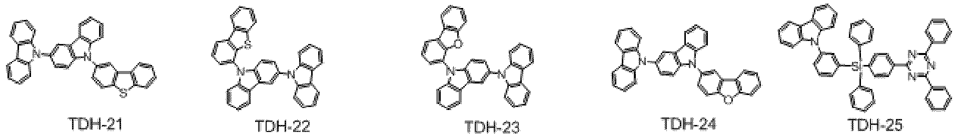

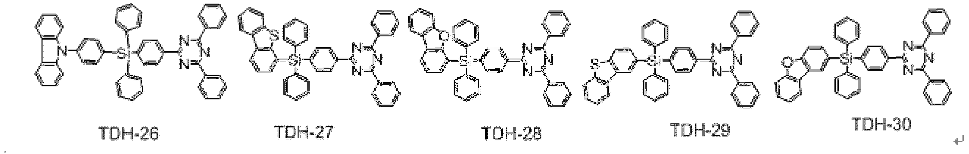

In an optional embodiment, the TADF sensitizer is selected from any one or a combination of at least two of the following compounds TDE1 to TDE37 (such as a combination of TDE3 and TDE8, a combination of TDE25 and TDE9 or a combination of TDE18, TDE21 and TDE35):

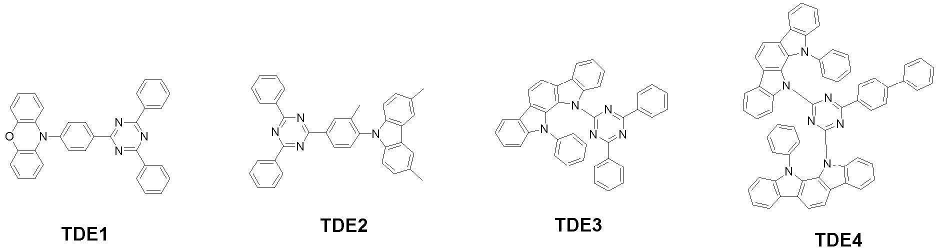

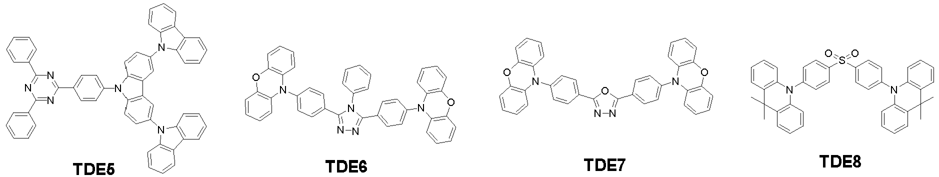

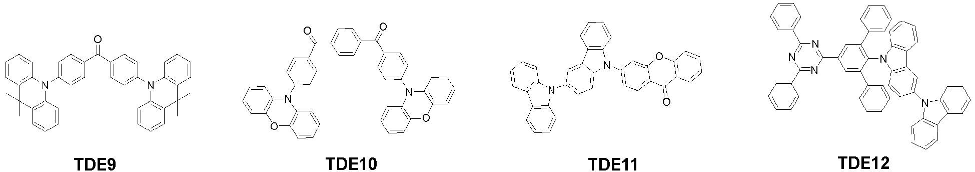

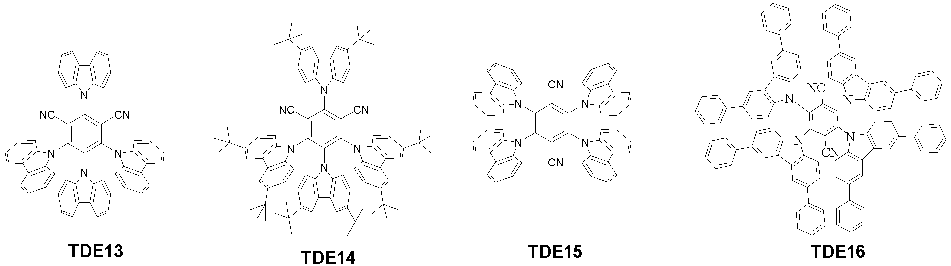

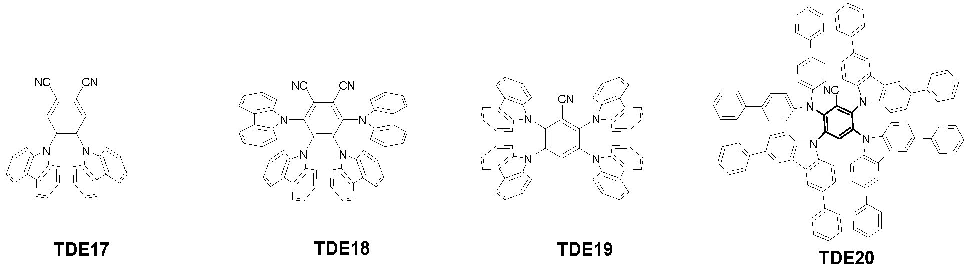

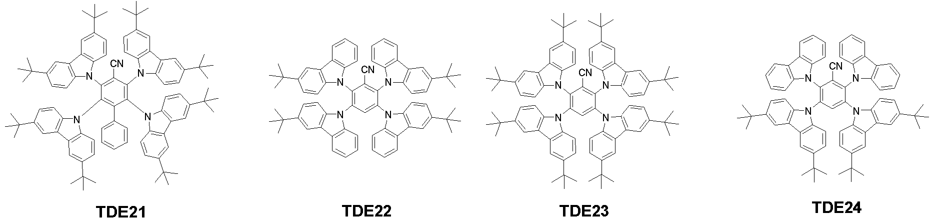

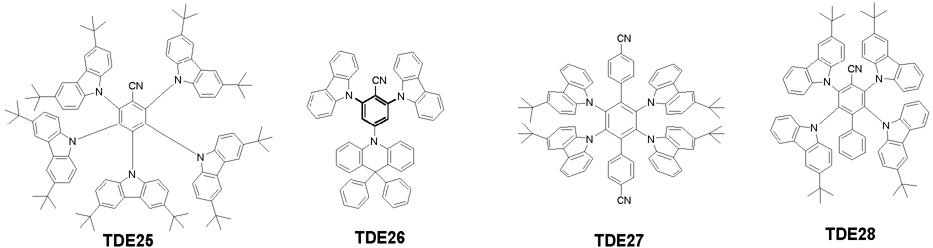

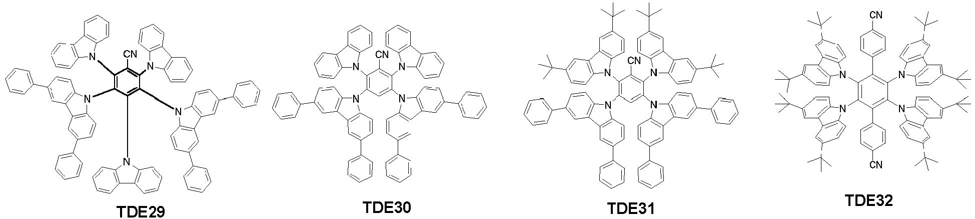

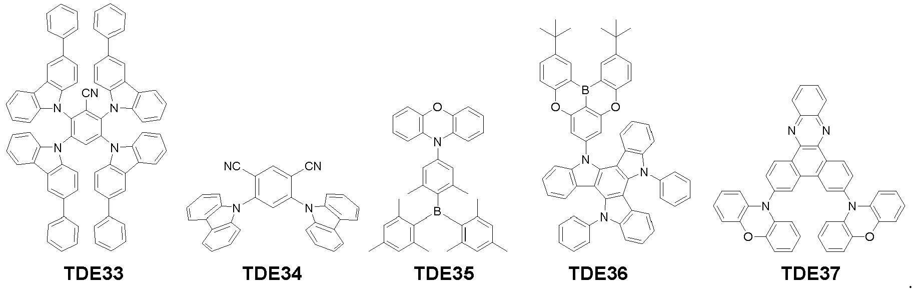

In an optional embodiment, a mass of the fluorescent dye accounts for 0.1% to 10% of a total mass of the EML (which can be referred to as a doping concentration for short), preferably 0.2%, 0.3%, 0.4%, 0.5%, 0.6%, 0.8%, 1%, 1.5%, 2%, 2.5%, 3%, 3.5%, 4%, 4.5%, 5%, 5.5%, 6%, 6.5%, 7%, 7.5%, 8%, 8.5%, 9%, 9.5% or the like, and further preferably 1%.

For the fluorescent dye having the specific structure selected in the present application, the doping concentration of the fluorescent dye in the EML is further optimized. Within the above concentration range, the performance of the TASF device is further improved. If the doping amount is too low, less dye molecules participate in light emission, and the device efficiency is relatively low; if the doping amount is too high, the quenching of the dye in the device is exacerbated, resulting in poorer device efficiency, drive voltage and device service life.

In an optional embodiment, a mass of the TADF sensitizer accounts for 1% to 99% of the total mass of the EML, preferably 2%, 5%, 10%, 15%, 20%, 25%, 30%, 35%, 40%, 45%, 50%, 55%, 60%, 65%, 70%, 75%, 80%, 85%, 90%, 95% or the like, and further preferably 10% to 50%.

In an optional embodiment, the organic layer further comprises any one or a combination of at least two of a hole injection layer (HIL), a hole transport layer (HTL), a hole blocking layer (HBL), an electron blocking layer (EBL), an electron transport layer (ETL) or an electron injection layer (EIL).

Embodiments of the present application further provide a display apparatus. The display apparatus comprises the organic electroluminescent device as provided above. Specifically, the display apparatus can be an organic light-emitting diode (OLED) display panel and any product or component having a display function such as a television, a digital camera, a mobile phone and a tablet computer including the display panel. The advantages of the display apparatus are the same as those of the above organic electroluminescent device relative to the existing art, which are not repeated here.

It is to be understood that the first electrode and the second electrode in the present application represent an anode and a cathode, respectively.

The hole transport region, the electron transport region, the anode and the cathode of the present application are described below. The hole transport region is located between the anode and the EML. The hole transport region is an HTL having a monolayer structure, which comprises a monolayer HTL containing only one compound and a monolayer HTL containing a plurality of compounds. The hole transport region can also be a multilayer structure including at least two of the HIL, the HTL or the EBL.

A material of the hole transport region (including the HIL and the HTL) can be selected from, but is not limited to, phthalocyanine derivatives such as CuPc, and conductive polymers or polymers containing a conductive dopant such as poly(p-phenylenevinylene), polyaniline/dodecylbenzenesulfonic acid (Pani/DBSA), poly(3,4-ethylenedioxythiophene)/poly(sodium 4-styrenesulfonate) (PEDOT/PSS), polyaniline/camphorsulfonic acid (Pani/CSA), polyaniline/poly(sodium 4-styrenesulfonate) (Pani/PSS) and aromatic amine derivatives.

The aromatic amine derivatives are compounds represented by the following HT-1 to HT-34. If the material of the hole transport region is an aromatic amine derivative, the aromatic amine derivative can be one or a combination of at least two of the compounds represented by HT-1 to HT-34 (such as a combination of HT-5 and HT-8 or a combination of HT-11, HT-12 and HT-15).

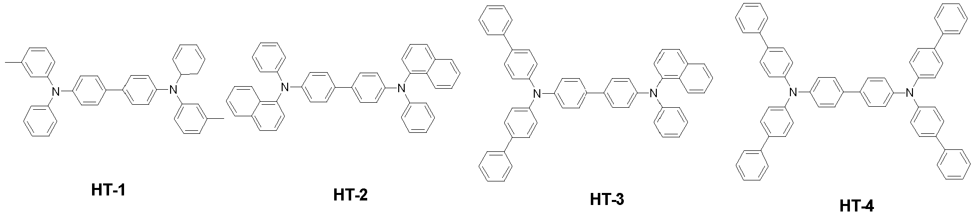

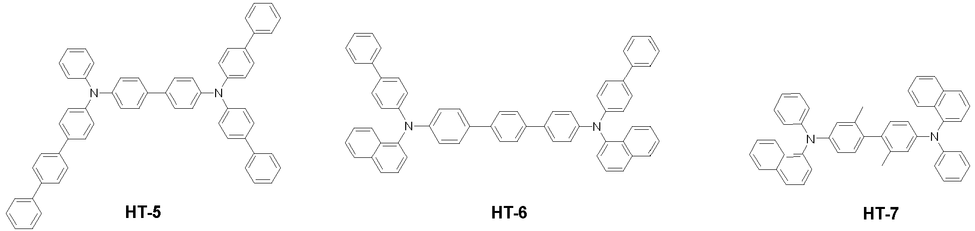

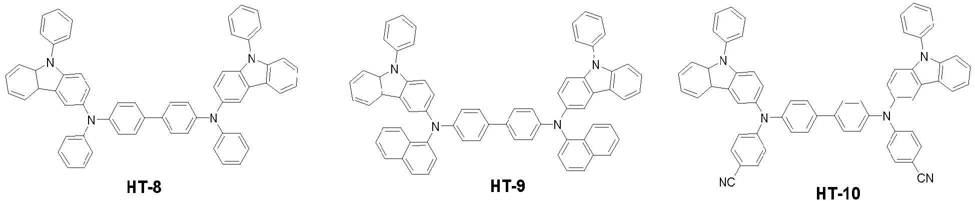

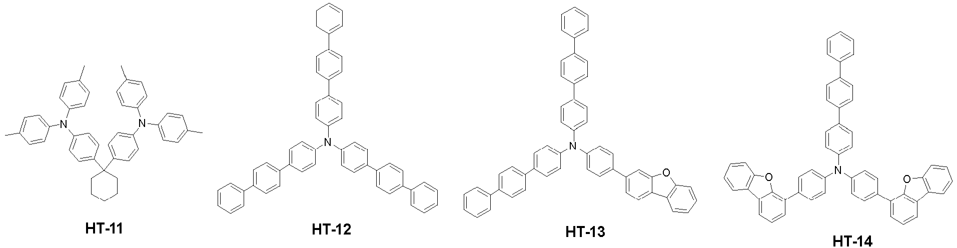

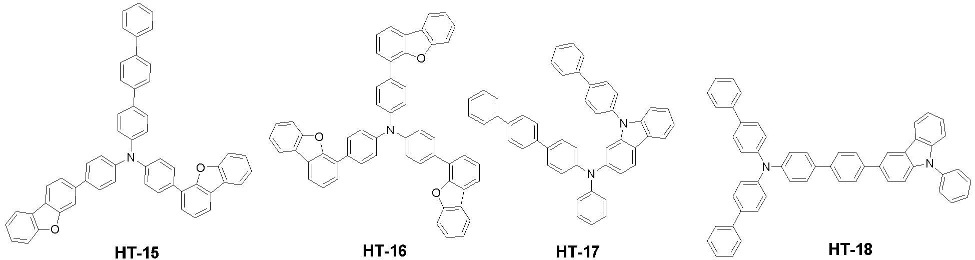

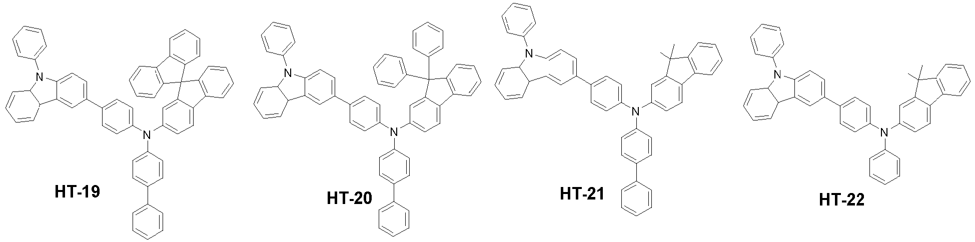

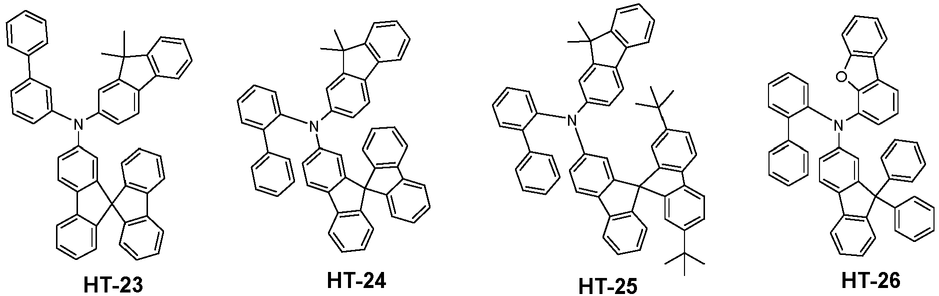

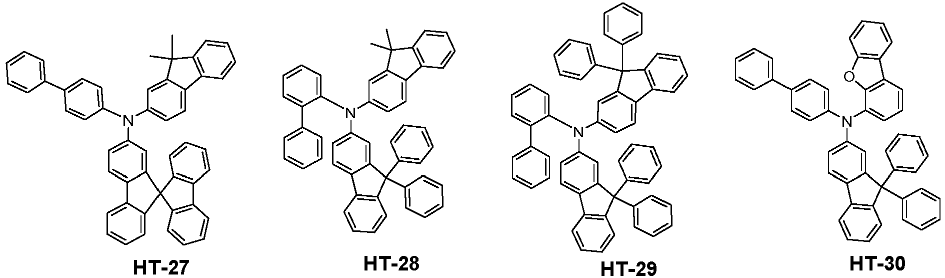

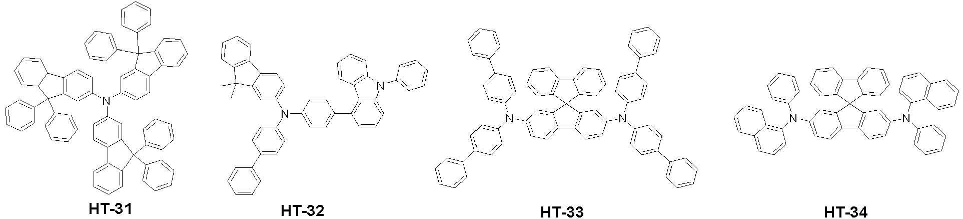

The HIL is located between the anode and the HTL. The HIL may be a single compound material or a combination of a plurality of compounds. For example, the HIL may use one or at least two compounds of HT-1 to HT-34 described above, or one or a combination of at least two of HI-1 to HI-3 described below; and the HIL may also use one or a combination of at least two of HT-1 to HT-34 doped with one or a combination of at least two of HI-1 to HI-3 described below (such as a combination of HI-1 and HI-2).

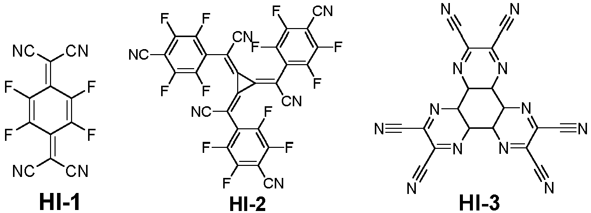

The electron transport region may be an ETL having a monolayer structure, which comprises a monolayer ETL containing only one compound and a monolayer ETL containing a plurality of compounds. The electron transport region may also be a multilayer structure including at least two of the EIL, the ETL or the HBL.

Further, in the embodiment of the present application, a material of the ETL may be selected from, but is not limited to, one or a combination of at least two of ET-1 to ET-65 listed below (such as a combination of ET-2 and ET-9 or a combination of ET-12, ET-17 and ET-33).

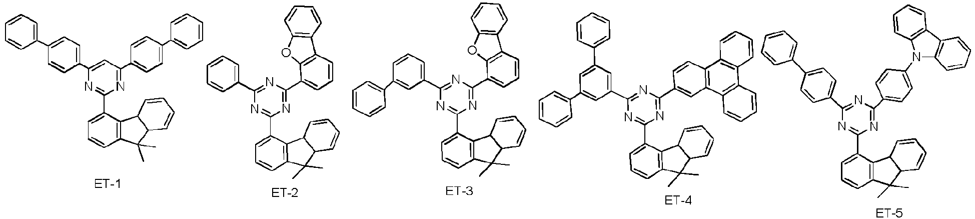

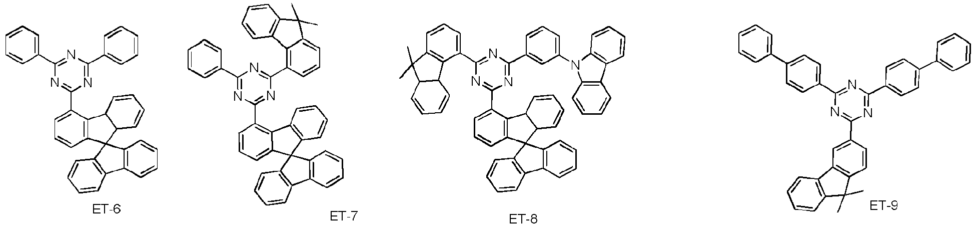

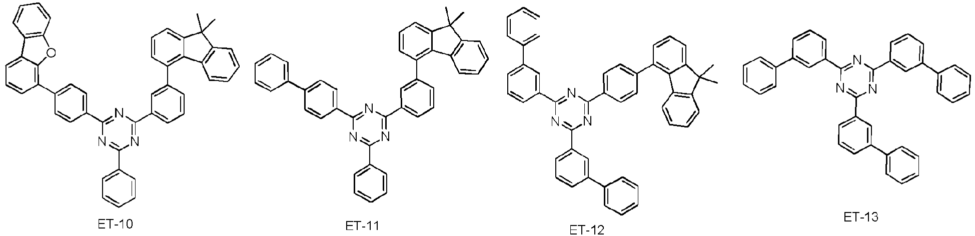

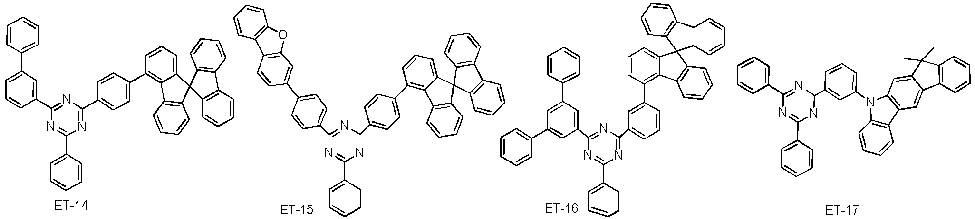

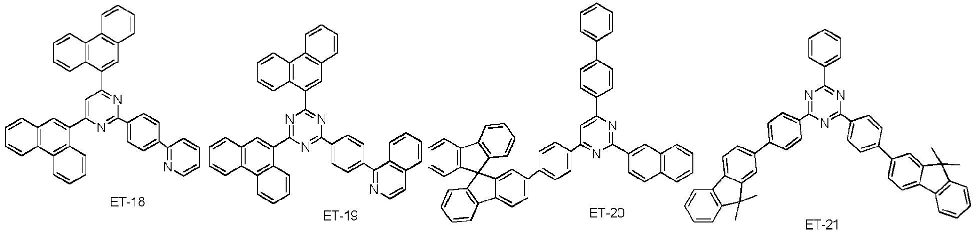

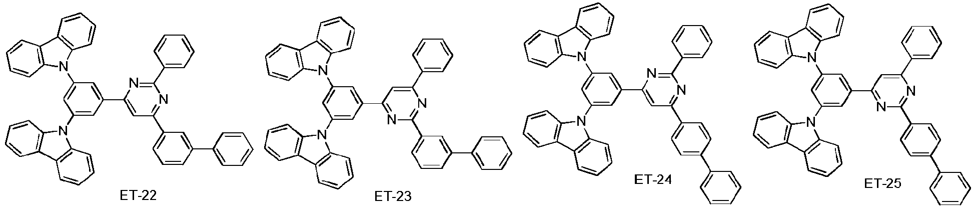

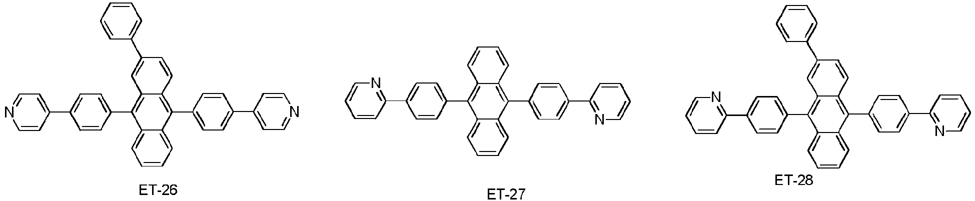

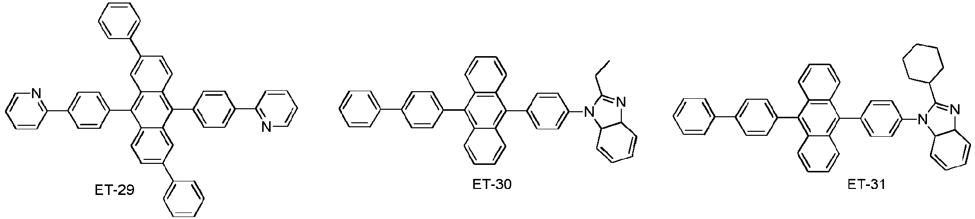

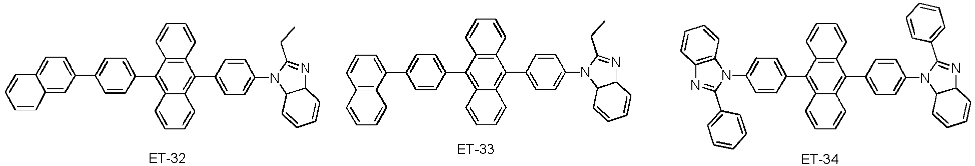

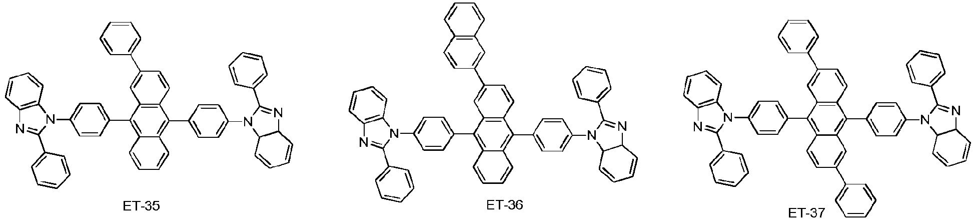

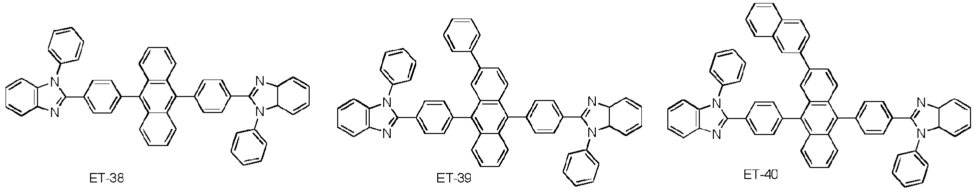

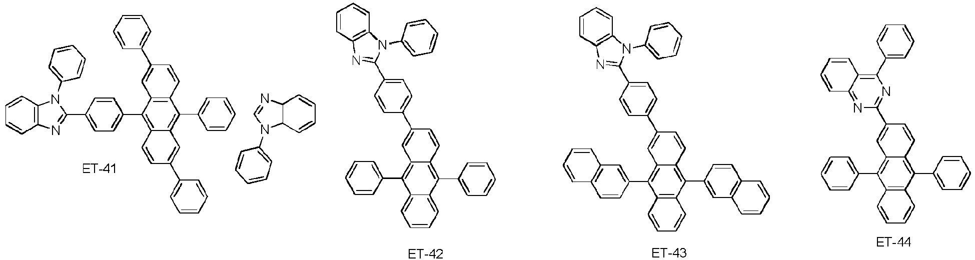

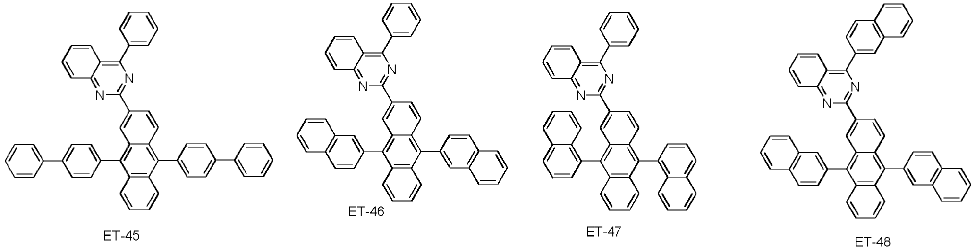

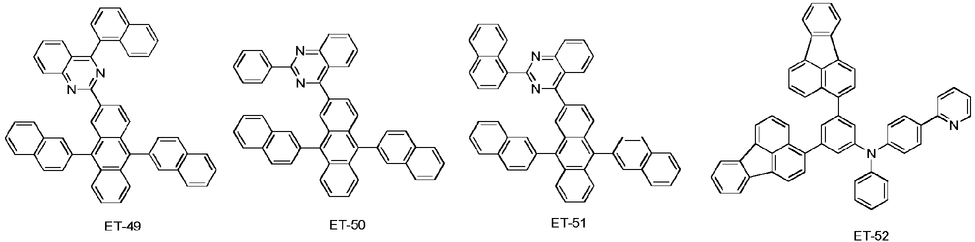

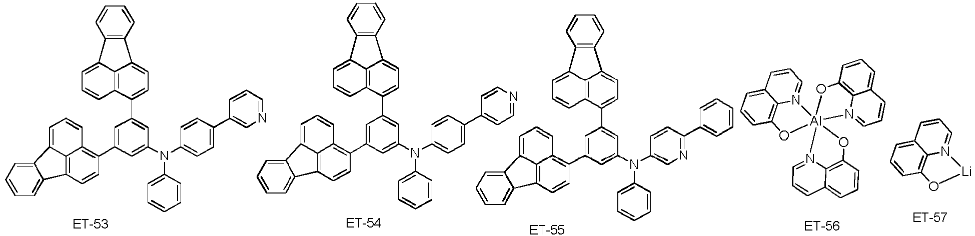

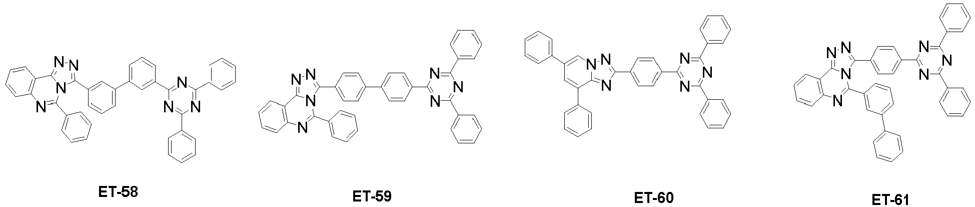

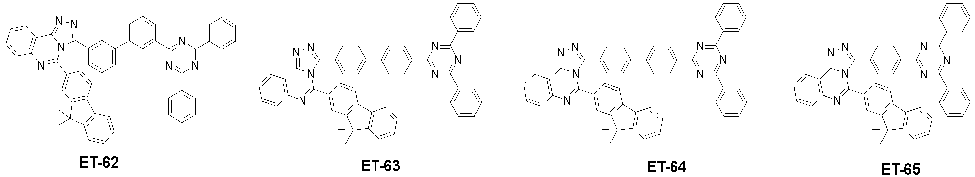

In an optional embodiment, a hole blocking material of the HBL is selected from any one or a combination of at least two of the compounds represented by the following HB-1 to HB-6 (such as a combination of HB-1 and HB-2, a combination of HB-5, HB-6 and HB-4 or a combination of HB-1, HB-3, HB-4 and HB-6):

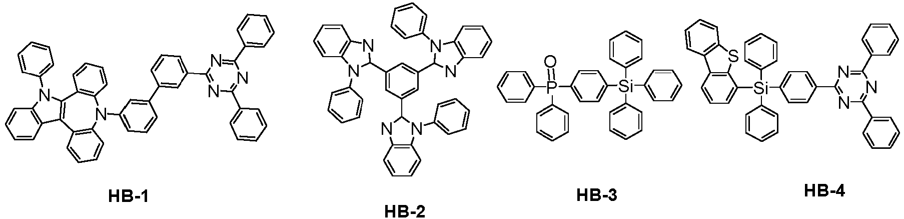

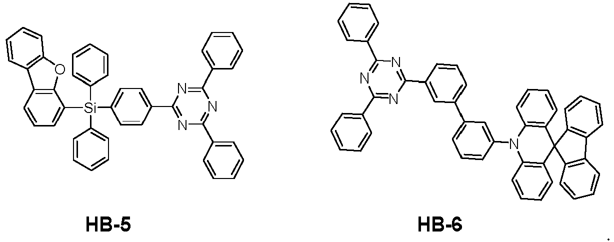

In an optional embodiment, an electron blocking material of the EBL is selected from any one or a combination of at least two of the compounds represented by the following EB-1 to EB-21 and compounds TDH-1 to TDH-30:

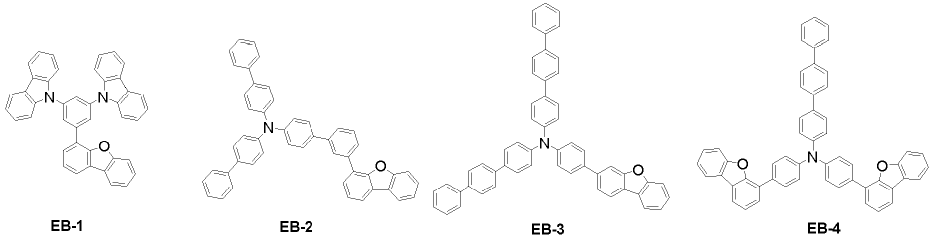

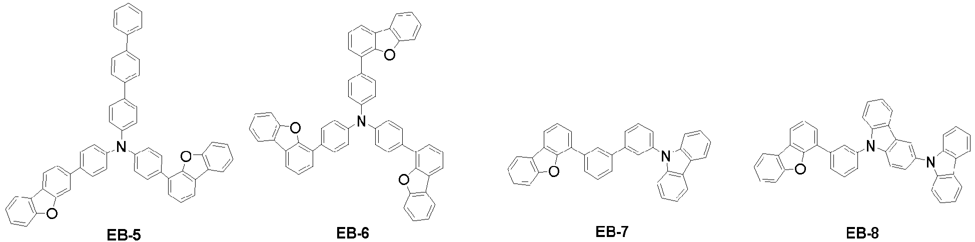

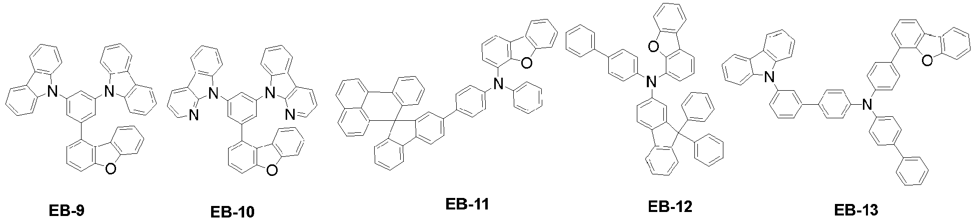

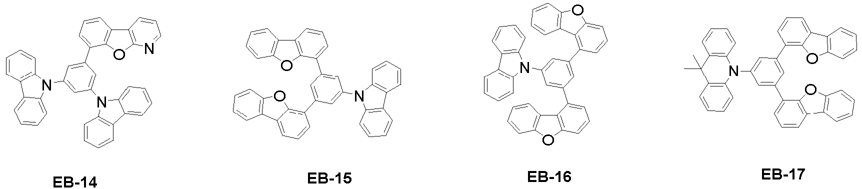

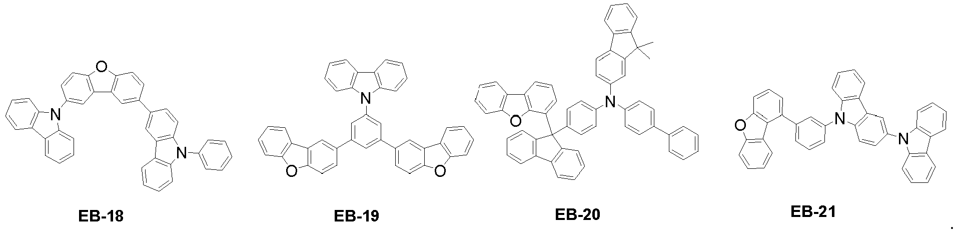

In an optional embodiment, an electron injection material of the EIL comprises any one or a combination of at least two of the following compounds:
Liq, LiF, NaCl, CsF, Li₂O, Cs₂CO₃, BaO, Na, Li, Ca, Mg, Ag and Yb.

In an optional embodiment, a substrate may be used below the first electrode or above the second electrode. The substrate is glass or a polymeric material having mechanical strength, thermal stability, waterproof property and excellent transparency. In addition, a thin-film transistor (TFT) can also be disposed on a substrate used as a display.

In an optional embodiment, the first electrode may be formed in a manner of sputtering or depositing a material used as the first electrode on the substrate. When the first electrode is used as the anode, a transparent conductive oxide material, such as indium tin oxide (ITO), indium zinc oxide (IZO), tin(IV) oxide (SnO₂) or zinc oxide (ZnO) or any combination thereof, may be used. When the first electrode is used as the cathode, a metal or an alloy, such as magnesium (Mg), silver (Ag), aluminum (Al), aluminum-lithium (Al-Li), calcium (Ca), magnesium-indium (Mg-In) or magnesium-silver (Mg-Ag) or any combination thereof, may be used.

In the device, a capping layer (CPL layer) can be evaporated above the cathode to improve the device efficiency and adjust an optical microcavity.

The thicknesses of the above layers may use conventional thicknesses of the layers in the art. The present application further provides a method for preparing the organic electroluminescent device. The method comprises sequentially depositing an anode, a hole transport region, an EML, an electron transport region and a cathode on a substrate followed by encapsulation. When the EML is prepared, a multi-component co-deposition method is used. The deposition manners of the anode, the hole transport region, the electron transport region and the cathode are the same as the existing manners in the art.

Exemplarily, the following synthesis examples of reference compounds that are useful for understanding the synthesis of the fluorescent dye as claimed. An

ABSCIEX mass spectrometer (4000QTRAP) is used for the analysis and detection of compounds.

### Synthesis Example 1: Synthesis of M1 (not according to the invention)

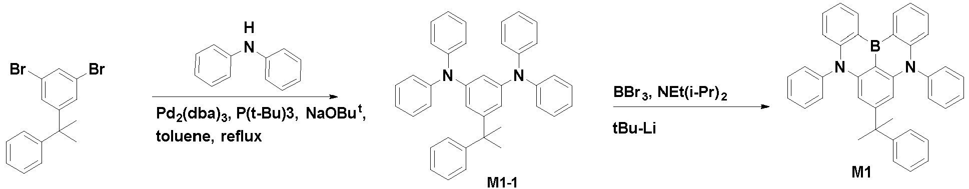

### Synthesis of Intermediate M1-1

At room temperature, 1,3-dibromo-5-(2-phenylpropan-2-yl)benzene (35.2 g, 100 mmol), diphenylamine (41.7 g, 250 mmol), Pd₂(dba)₃ (0.92 g, 1 mmol), s-Phos (0.82 g, 2 mmol), sodium tert-butoxide (24 g, 250 mmol) and xylene (500 mL) were added to a 1 L single-necked flask, purged with nitrogen three times, heated to 130 °C and reacted overnight. The reaction solution was cooled to room temperature. The reaction system was concentrated, extracted with dichloromethane and washed with a large amount of water. The organic phases were dried, concentrated and subjected to column chromatography (PE:DCM = 20:1) to obtain a crude product (42.4 g). The crude product was heated, boiled and washed with n-hexane to obtain a white solid (33.1 g) with a yield of 62.4%.

The molecular determined through mass spectrometry is 530.29 (theoretical value: 530.27).

### Synthesis of Compound M1

M1-1 (5.3 g, 10 mmol) was added to a 250 mL three-necked flask. *p-tert*-Butylbenzene (80 mL) was added and stirred for 20 minutes. The reaction system was cooled to -20 °C, and then, tert-butyllithium (15 mmol) was added. The reaction system continued to be stirred for 30 minutes at a low temperature which was maintained. Then, the temperature was gradually increased to 90 °C, and the reaction system was continuously heated for 3 h. Finally, the reaction system was reduced to -20 °C again. Under nitrogen protection, boron tribromide (5.1 g, 20 mmol) was added and stirred for 30 minutes, and then diisopropylethylamine (13 g, 80 mmol) was added. Finally, the reaction system was heated to 110 °C and reacted for 12 h. After the reaction system was cooled to room temperature, the organic phases were subjected to rotary evaporation to dryness under reduced pressure. The reaction system was extracted with ethyl acetate (200 mL) three times. The organic phases were combined and dried with anhydrous sodium sulfate. The organic phases were mixed with silica gel, concentrated and subjected to column chromatography (PE:DCM = 100:1) to obtain a crude product (2.1 g). The crude product was recrystallized with toluene/n-hexane to obtain a yellow solid (0.95 g) with a yield of 17.6%.

The molecular mass determined through mass spectrometry is 538.22 (theoretical value: 538.26).

### Synthesis Example 2: Synthesis of M6 (not according to the invention)

The synthesis method of M6 was similar to that of M1, except that diphenylamine was replaced with bis(4-tert-butylphenyl)amine in an equivalent amount of substance to obtain a compound M6 with a yield of 15.1%. The molecular ion mass determined through molecular mass spectrometry is 762.49 (theoretical value: 762.51).

### Synthesis Example 3: Synthesis of M37 (not according to the invention)

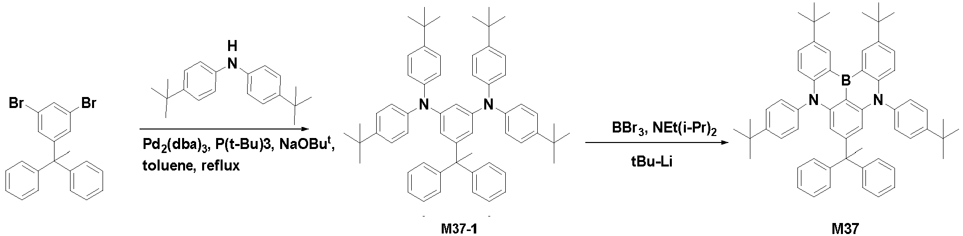

### Synthesis of Intermediate M37-1

At room temperature, (1-(3,5-dibromophenyl)ethane-1,1-diphenyl)diphenyl (41.4 g, 100 mmol), bis(4-tert-butylphenyl)amine (90.0 g, 320 mmol), Pd₂(dba)₃ (2.8 g, 3 mmol), 2-dicyclohexylphosphino-2',6'-dimethoxybiphenyl (s-Phos) (1.2 g, 3 mmol), sodium tert-butoxide (33.6 g, 350 mmol) and xylene (1200 mL) were added to a 2 L single-necked flask, purged with nitrogen three times, heated to 130 °C and reacted overnight. The reaction solution was cooled to room temperature, extracted with ethyl acetate and washed with a large amount of water. The organic phases were dried, concentrated and subjected to column chromatography (PE:DCM = 20:1) to obtain a white solid (66.4 g) with a yield of 81.4%.

The molecular mass determined through mass spectrometry is 816.58 (theoretical value: 816.54).

### Synthesis of Compound M37

M53-1 (8.2 g, 10 mmol) was added to a 500 mL three-necked flask. *p-tert*-Butylbenzene (150 mL) was added and stirred for 20 minutes. The reaction system was cooled to -20 °C, and *tert*-butyllithium (15 mmol) was added. The reaction system continued to be stirred for 30 minutes at a low temperature which was maintained. Then, the temperature was gradually increased to 90 °C, and the reaction system was continuously heated for 3 h. Finally, the reaction system was reduced to -20 °C again. Under nitrogen protection, boron tribromide (5.1 g, 20 mmol) was added and stirred for 30 minutes, and then diisopropylethylamine (13 g, 80 mmol) was added. Finally, the reaction system was heated to 110 °C and reacted for 12 h. After the reaction system was cooled to room temperature, the organic phases were subjected to rotary evaporation to dryness under reduced pressure. The reaction system was extracted with ethyl acetate (200 mL) three times. The organic phases were combined and dried with anhydrous sodium sulfate. The organic phases were mixed with silica gel, concentrated and subjected to column chromatography (PE:DCM = 40:1) to obtain a crude product (1.9 g). The crude product was recrystallized with toluene/n-hexane to obtain a yellow solid (1.1 g) with a yield of 13.3%. The molecular mass determined through mass spectrometry is 824.54 (theoretical value: 824.52).

### Synthesis Example 4: Synthesis of M49 (not according to the invention)

The synthesis method of M49 was similar to that of M37, except that diphenylamine was replaced with bis(3-tert-butylphenyl)amine in an equivalent amount of substance to obtain Compound M49 with a yield of 15.5%. The molecular mass determined through molecular mass spectrometry is 816.57 (theoretical value: 816.54).

### Synthesis Example 5: Synthesis of M55 (not according to the invention)

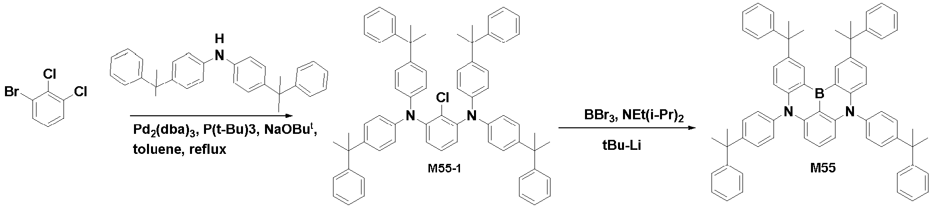

### Synthesis of Intermediate M55-1

At room temperature, 1-bromo-2,3-dichlorobenzene (22.4 g, 100 mmol), bis(4-(2-phenylpropan-2-yl)phenyl)amine (129.7 g, 320 mmol), Pd₂(dba)₃ (2.8 g, 3 mmol), s-Phos (1.2 g, 3 mmol), sodium tert-butoxide (33.6 g, 350 mmol) and xylene (1200 mL) were added to a 2 L single-necked flask, purged with nitrogen three times, heated to 130 °C and reacted overnight. The reaction solution was cooled to room temperature, extracted with ethyl acetate and washed with a large amount of water. The organic phases were dried, concentrated and subjected to column chromatography (PE:DCM = 15:1) to obtain a white solid (60.8 g) with a yield of 66.2%.

The molecular mass determined through mass spectrometry is 918.48 (theoretical value: 918.47).

### Synthesis of Compound M55

M55-1 (9.2 g, 10 mmol) was added to a 500 mL three-necked flask. *p-tert*-Butylbenzene (150 mL) was added and stirred for 20 minutes. The reaction system was cooled to -20 °C, and then *tert*-butyllithium (15 mmol) was added. The reaction system continued to be stirred for 30 minutes at a low temperature which was maintained. Then, the temperature was gradually increased to 90 °C, and the reaction system was continuously heated for 3 h. Finally, the reaction system was reduced to -20 °C again. Under nitrogen protection, boron tribromide (5.1 g, 20 mmol) was added and stirred for 30 minutes, and diisopropylethylamine (13 g, 80 mmol) was added. Finally, the reaction system was heated to 110 °C and reacted for 12 h. After the reaction was cooled to room temperature, the organic phases were subjected to rotary evaporation to dryness under reduced pressure. The reaction system was extracted with ethyl acetate (200 mL) three times. The organic phases were combined and dried with anhydrous sodium sulfate. The organic phases were mixed with silica gel, concentrated and subjected to column chromatography (PE:DCM = 40:1) to obtain a crude product (3.2 g). The crude product was recrystallized with toluene/n-hexane to obtain a yellow solid (2.3 g) with a yield of 26.3%. The molecular mass determined through mass spectrometry is 892.45 (theoretical value: 892.49).

### Synthesis Example 6: Synthesis of M66 (not according to the invention)

The synthesis method of M66 was similar to that of M55, except that 1-bromo-2,3-dichlorobenzene was replaced with 1-bromo-2,3-dichloro-5-methylbenzene in an equivalent amount of substance to obtain a compound M66 with a yield of 23.5%. The molecular mass determined through molecular mass spectrometry is 906.48 (theoretical value: 906.51).

### Synthesis Example 7: Synthesis of M89 (not according to the invention)

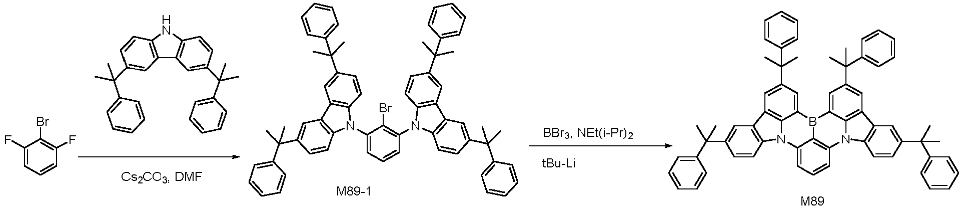

### Synthesis of Intermediate M89-1

At room temperature, 3,6-bis(2-phenylpropan-2yl)carbazole (34.3 g, 85 mmol), 2-bromo-1,3-difluorobenzene (7.7 g, 40 mmol), cesium carbonate (32.6 g, 100 mmol) and N,N-dimethylformamide (350 mL) were added to a 500 mL single-necked flask, purged with nitrogen three times, heated to 130 °C and reacted overnight. After the reaction was stopped and the reaction system was cooled to room temperature, 500 mL water was added and stirred for 10 min. A large amount of white solids were precipitated and subjected to suction filtration. The filter cake was boiled and washed with ethanol for 2 h and subjected to suction filtration at a reduced temperature to obtain a white solid product (37.4 g) with a yield of 97.6%. The molecular mass determined through mass spectrometry is 958.42 (theoretical value: 958.39).

### Synthesis of Compound M89

M89-1 (9.6 g, 10 mmol) was added to a 500 mL three-necked flask. *p-tert*-Butylbenzene (100 mL) was added and stirred for 20 minutes. The reaction system was cooled to -20 °C, and tert-butyllithium (15 mmol) was added. The reaction system continued to be stirred for 30 minutes at a low temperature which was maintained. Then, the temperature was gradually increased to 90 °C, and the reaction system was continuously heated for 3 h. Finally, the reaction system was reduced to -20 °C again. Under nitrogen protection, boron tribromide (5.1 g, 20 mmol) was added and stirred for 30 minutes, and then diisopropylethylamine (13 g, 80 mmol) was added. Finally, the reaction system was heated to 110 °C and reacted for 12 h. After the reaction system was cooled to room temperature, the organic phases were subjected to rotary evaporation to dryness under reduced pressure. The reaction system was extracted with ethyl acetate (200 mL) three times. The organic phases were combined and dried with anhydrous sodium sulfate. The organic phases were mixed with silica gel, concentrated and subjected to column chromatography (PE:DCM = 40:1) to obtain a crude product (1.9 g). The crude product was recrystallized with toluene/n-hexane to obtain a yellow solid (1.2 g) with a yield of 20.3%. The molecular mass determined through mass spectrometry is 888.47 (theoretical value: 888.46).

### Synthesis Example 8: Synthesis of M90 (not according to the invention)

The synthesis method of M90 was similar to that of M89, except that 2-bromo-1,3-difluobenzene was replaced with 2-bromo-1,3-difluoro-5-methylbenzene in an equivalent amount of substance to obtain Compound M90 with a yield of 19.6%. The molecular mass determined through molecular mass spectrometry is 902.51 (theoretical value: 902.48). The synthesis methods of other compounds were similar. The other compounds were synthesized according to related synthesis general formulas and confirmed through a mass spectrometry test. The results are as follows:

**Table 1 Results of mass spectrometry test of compounds (for Reference)**

| Compound Number | Theoretical Value of Mass Spectrometry | Test Data of Mass Spectrometry |
|---|---|---|
| M3 | 606.40 | 606.62 |
| M14 | 762.51 | 762.66 |
| M31 | 850.54 | 850.81 |
| M44 | 824.52 | 824.96 |
| M76 | 822.51 | 822.63 |
| M81 | 764.43 | 764.64 |
| M102 | 778.49 | 778.72 |
| M106 | 778.49 | 778.83 |
| M108 | 1026.55 | 1026.87 |

The organic electroluminescent device of the present application is further described below through specific embodiments.

Reference embodiments one to twenty-one and comparative examples one and two

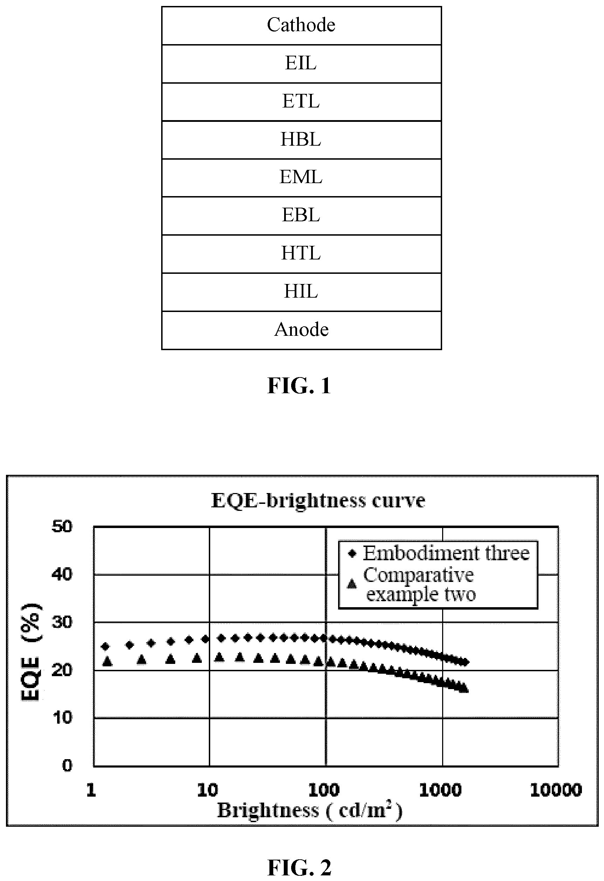

All of the reference embodiments are not according to the invention. above embodiments and comparative examples each provide an organic electroluminescent device having a structure shown in FIG. 1, including, from top to bottom, an anode, an HIL, an HTL, an EBL, an EML, an HBL, an ETL, an EIL and a cathode in sequence, where the EML comprises a host material, a TADF sensitizer and a fluorescent dye, and a specific selection of materials is shown in detail in Table 1.

A specific method for preparing the organic electroluminescent device is described below.
(1) A glass plate coated with an ITO transparent conductive layer was sonicated in a commercial cleaning agent, rinsed in deionized water, performed ultrasonic oil removal in an acetone: ethanol mixed solvent, baked in a clean environment to completely remove moisture, washed with ultraviolet light and ozone, and bombarded the surface with a low-energy cation beam.
(2) The above glass substrate with an anode was placed in a vacuum chamber. The vacuum chamber was vacuumized to less than 1×10⁻⁵ Pa. HI-3 was evaporated through vacuum evaporation on a film of the above anode layer as an HIL, where an evaporation rate was 0.1 nm/s, and the evaporated film had a thickness of 2 nm.
(3) An HTL HT-28 was evaporated through vacuum evaporation on the HIL, where an evaporation rate was 0.1 nm/s, and the evaporated film had a total thickness of 30 nm.
(4) An EBL EB-12 was evaporated through vacuum evaporation on the HTL, where an evaporation rate was 0.1 nm/s, and the evaporated film had a total thickness of 5 nm.
(5) An EML, which comprises a host material, a sensitizer and a fluorescent dye, was evaporated through vacuum evaporation on the EBL using a multi-component co-deposition method, where a host evaporation rate was 0.1 nm/s, and the evaporated film had a thickness of 30 nm.
(6) HB-5 was evaporated through vacuum evaporation on the EML as an HBL, where an evaporation rate was 0.1 nm/s, and the evaporated film had a total thickness of 5 nm.
(7) EB-60 and ET-57 were evaporated through vacuum evaporation on the HBL as an ETL at a ratio of 1:1, where an evaporation rate was 0.1 nm/s, and the evaporated film had a total thickness of 25 nm.
(8) Liq with a thickness of 1 nm was evaporated through vacuum evaporation on the ETL as an EIL, and an Al layer with a thickness of 150 nm was evaporated through vacuum evaporation as a cathode of the device.

The fluorescent dyes used in comparative examples one and two each have a structure of D1 or D2:

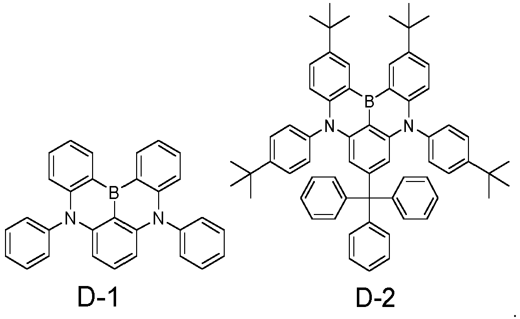

### Device Performance Test

(1) At the same brightness, the drive voltages and the external quantum efficiency of the organic electroluminescent devices prepared in the device embodiments and the device comparative examples were measured using a digital source meter and PR650. Specifically, the voltage was increased at a rate of 0.1 V per second, and a voltage measured when the brightness of the organic electroluminescent device reached 1000 cd/m² was a drive voltage at the corresponding brightness. Moreover, the external quantum efficiency (EQE, %) of the device can be directly tested on PR650.
(2) Service life test

At the brightness of 1000 cd/m², a constant current was maintained, and a brightness meter was used for measuring the time for the brightness of the organic electroluminescent device to reduce to 800 cd/m², which was referred to an LT80 service life of the device. In this test, the service life of comparative example one was denoted as 100%, and the service life values of other embodiments or comparative examples were all expressed in proportion to that of comparative example one.

The results of the above test are shown in Table 2. Table 2 Results of device performance test of non-inventive devices

| | Emission Layer | | | Drive Voltage (V) | External Quantum Efficiency (%) | LT80 Service Life |
|---|---|---|---|---|---|---|
| | Host Material | Sensitizer and Doping Concentration | Fluorescent Dye and Doping Concentration | | | |
| Embodiment one | TDH-1 | TDE23 (40%) | M6 (0.05%) | 5.0 | 19.5% | 190% |
| Embodiment two | TDH-1 | TDE23 (40%) | M6 (0.1%) | 4.6 | 22.4% | 192% |
| Embodiment three | TDH-1 | TDE23 (40%) | M6 (1%) | 4.4 | 23.3% | 216% |
| Embodiment four | TDH-1 | TDE23 (40%) | M6 (10%) | 4.7 | 21.6% | 208% |
| Embodiment five | TDH-1 | TDE23 (40%) | M6 (12%) | 4.9 | 20.7% | 189% |
| Embodiment six | TDH-1 | TDE23 (40%) | M1 (1%) | 4.5 | 22.4% | 207% |
| Embodiment seven | TDH-1 | TDE23 (40%) | M102 (1%) | 5.0 | 20.0% | 168% |
| Embodiment eight | TDH-2 | TDE23 (30%) | M3 (1%) | 4.7 | 21.6% | 189% |
| Embodiment nine | TDH-6 | TDE33 (80%) | M14 (1%) | 4.7 | 22.1% | 171% |
| Embodiment ten | TDH-10 | TDE34 (10%) | M31 (1%) | 45.0 | 20.0% | 165% |
| Embodiment eleven | TDH-15 | TDE12 (40%) | M44 (1%) | 4.8 | 19.8% | 173% |
| Embodiment twelve | TDH-6 | TDE25 (40%) | M49 (1%) | 4.7 | 21.9% | 181% |
| Embodiment thirteen | TDH-20 | TDE16 (40%) | M55 (1%) | 4.6 | 21.4% | 155% |
| Embodiment fourteen | TDH-23 | TDE9 (40%) | M76 (1%) | 4.8 | 21.2% | 176% |
| Embodiment fifteen | TDH-30 | TDE3 (40%) | M81 (1%) | 4.9 | 20.8% | 159% |
| Embodiment sixteen | TDH-19 | TDE14 (40%) | M106 (1%) | 4.8 | 20.9% | 144% |
| Embodiment seventeen | TDH-17 | TDE18 (40%) | M108 (1%) | 4.7 | 19.6% | 137% |
| Embodiment eighteen | TDH-19 | TDE10 (40%) | M37 (1%) | 4.4 | 20.6% | 147% |
| Embodiment nineteen | TDH-18 | TDE3 (40%) | M66 (1%) | 4.6 | 20.5% | 149% |
| Embodiment twenty | TDH-27 | TDE27 (40%) | M89 (1%) | 4.8 | 20.6% | 157% |
| Embodiment twenty-one | TDH-20 | TDE22 (40%) | M90 (1%) | 4.7 | 19.8% | 174% |
| Comparative example one | TDH-1 | TDE23 (40%) | D-1 (1%) | 5.3 | 18.9% | 100% |
| Comparative example two | TDH-1 | TDE23 (40%) | D-2 (1%) | 5.6 | 17.7% | 110% |

As can be seen from Table 2, the non-inventive fluorescent dye having the specific structure is introduced into the EML of the TASF device so that the device performance can be effectively improved compared with the dye of the existing art, specifically, the drive voltage is reduced, and the external quantum efficiency and the service life are improved.

The fluorescent dye D-1 of comparative example one differs from the non-inventive fluorescent dye M1 of reference embodiment six only in the absence of a quaternary carbon substituent, and the non-inventive fluorescent dye D-2 of comparative example two differs from the non-inventive fluorescent dye M6 of reference embodiment three only in that all substitutions on quaternary carbon of D-2 are phenyl while there is a substitution of alkyl on quaternary carbon of M6. The data shows that the device performance of comparative examples one and two is apparently inferior to that of the reference embodiments, which proves that the quaternary carbon substituent in the fluorescent dye of the present application plays a crucial role.

As can be seen from a comparison among referencee embodiments one to five, the performance of the TASF device can be further improved when the doping proportion of the non-inventive fluorescent dye is controlled in a range of 0.1% to 10% (reference embodiments two to four), and the best effect is achieved when the doping amount is 1% (embodiment three).

As can be seen from a comparison between embodiments three and seven, the fluorescent dye containing an aryl-substituted quaternary carbon group (embodiment three) is more conducive to improving the performance of the TASF device compared with the fluorescent dye containing an aryl-substituted quaternary silicon group (embodiment seven).

FIG. 2 is a graph illustrating a comparison of external quantum efficiency-brightness between devices of embodiment three and comparative example two, which shows that the device of embodiment three has higher external quantum efficiency at the same brightness.

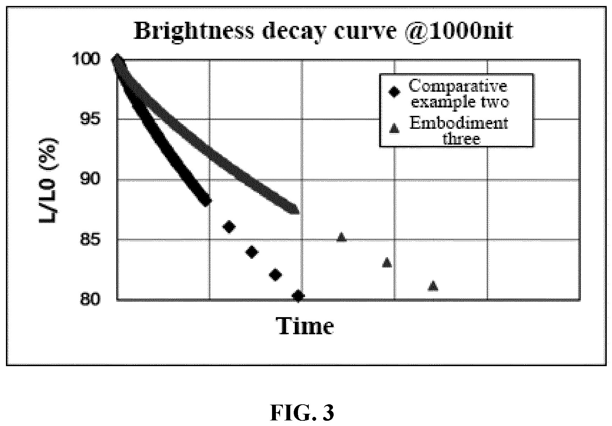

FIG. 3 is a graph illustrating brightness decay of devices of embodiment three and comparative example two at a brightness of 1000 cd/m², where L₀ represents an initial brightness, and L represents a brightness after corresponding time has passed, which shows that the device of embodiment three has a slower brightness decay rate.

## Claims

1. An organic electroluminescent device, comprising a first electrode, a second electrode and an organic layer disposed between the first electrode and the second electrode,
the organic layer comprises an emission layer, EML, the EML comprises a host material, a thermally activated delayed fluorescence, TADF, sensitizer and a fluorescent dye, and the fluorescent dye is selected from a compound represented by Formula (1): 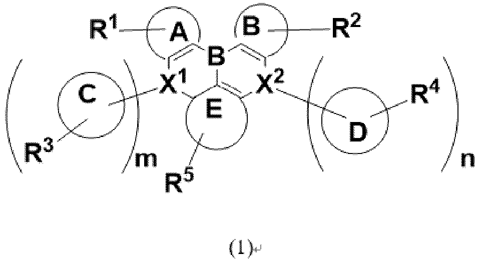 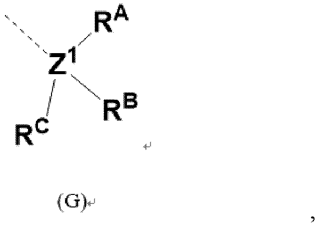
wherein in Formula (1):
the rings A, B, C, D and E each independently represent an aromatic ring or a heteroaromatic ring, and two adjacent rings are capable of being fused to form a five-membered ring or a six-membered ring containing X¹ or X²;
X¹ and X² are each independently selected from one of O, S, N, C or Si;
m is 0, 1 or 2, and n is 0, 1 or 2;
R¹, R², R³, R⁴ and R⁵ each independently represent from mono substitution to the maximum permissible substitution and are each independently selected from one or a combination of at least two of hydrogen, C₁ to C₁₀ chain alkyl, C₃ to C₁₀ cycloalkyl, C₁ to C₁₀ alkoxy, halogen, cyano, nitro, hydroxyl, ester, silicyl, amino, substituted or unsubstituted C₆ to C₃₀ arylamino, substituted or unsubstituted C₃ to C₃₀ heteroarylamino, substituted or unsubstituted C₆ to C₃₀ aryl or substituted or unsubstituted C₃ to C₃₀ heteroaryl, and at least one of R¹, R², R³, R⁴ and R⁵ is Formula (G);
wherein in Formula (G):
Z¹ is selected from C or Si;
R^{A}, R^{B} and R^{C} are each independently selected from one of C₁ to C₁₀ chain alkyl, C₃ to C₁₀ cycloalkyl, substituted or unsubstituted C₆ to C₃₀ aryl or substituted or unsubstituted C₃ to C₃₀ heteroaryl, at least one of R^{A}, R^{B} or R^{C} is substituted or unsubstituted C₆ to C₃₀ aryl or substituted or unsubstituted C₃ to C₃₀ heteroaryl, and at least one of R^{A}, R^{B} or R^{C} is C₁ to C₁₀ chain alkyl or C₃ to C₁₀ cycloalkyl; and
when a substituent is present in R^{A}, R^{B} and R^{C}, the substituent is selected from one or a combination of at least two of halogen, cyano, carboxy, C₁ to C₁₂ alkyl, C₃ to C₁₂ cycloalkyl, C₂ to C₁₀ alkenyl, C₁ to C₆ alkoxy or thioalkoxy, C₆ to C₃₀ monocyclic aryl or fused-ring aryl or C₃ to C₃₀ monocyclic heteroaryl or fused-ring heteroaryl;
**characterized in that**
the fluorescent dye is selected from any one or a combination of at least two of compounds represented by the following Formulas (IV), (V), (VI), (VII) or (VIII): 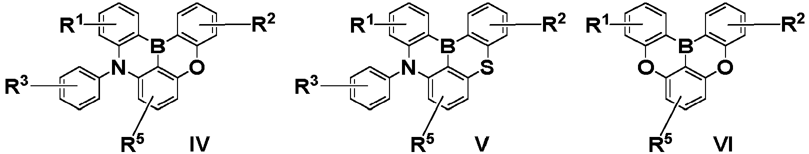 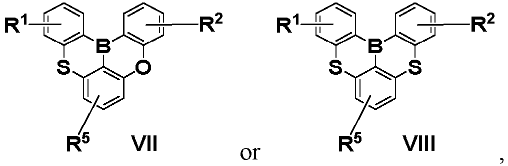
wherein R¹, R², R³ and R⁵ are as defined in the general Formula (1).

2. The organic electroluminescent device according to claim 1, wherein Formula (G) is the following Formula (G1): 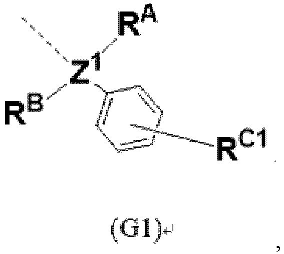 wherein in Formula (G1):
at least one of R^{A} or R^{B} is C₁ to C₁₀ chain alkyl or C₃ to C₁₀ cycloalkyl; and
R^{C1} is selected from one of hydrogen, C₁ to C₁₀ chain alkyl, C₃ to C₁₀ cycloalkyl, C₁ to C₁₀ alkoxy, substituted or unsubstituted C₆ to C₃₀ arylamino, substituted or unsubstituted C₃ to C₃₀ heteroarylamino, substituted or unsubstituted C₆ to C₃₀ aryl or substituted or unsubstituted C₃ to C₃₀ heteroaryl.

3. The organic electroluminescent device according to any one of claims 1 to 2, wherein Formula (G) is one of the following Formulas a, b, c or d: 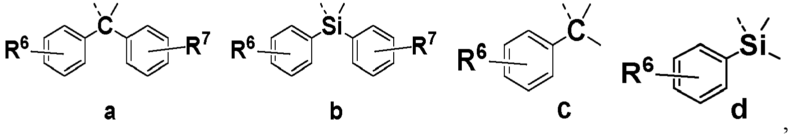 wherein R⁶ and R⁷ are each independently selected from one or a combination of at least two of hydrogen, deuterium, halogen, C₁ to C₁₀ chain alkyl or C₃ to C₁₀ cycloalkyl.

4. The organic electroluminescent device according to any one of claims 1 to 3, wherein the host material is selected from any one or a combination of at least two of the following compounds TDH-1 to TDH-30:

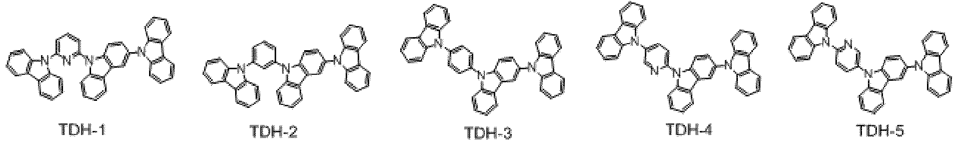

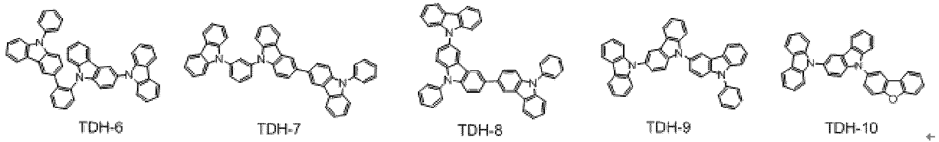

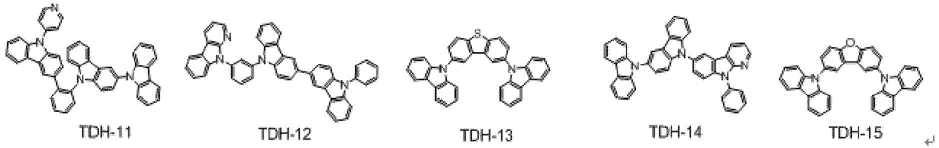

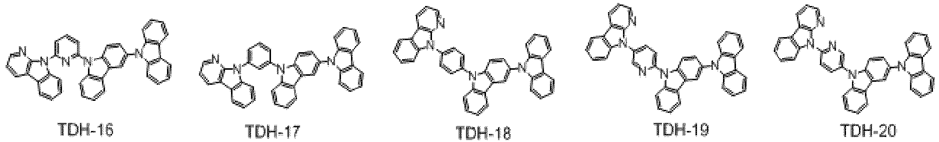

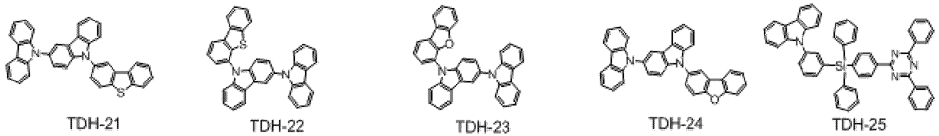

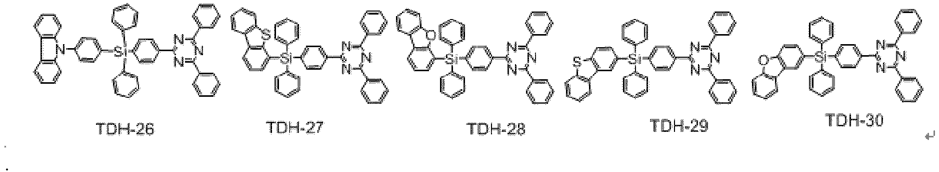

5. The organic electroluminescent device according to any one of claims 1 to 4, wherein the TADF sensitizer is selected from any one or a combination of at least two of the following compounds TDE1 to TDE37:

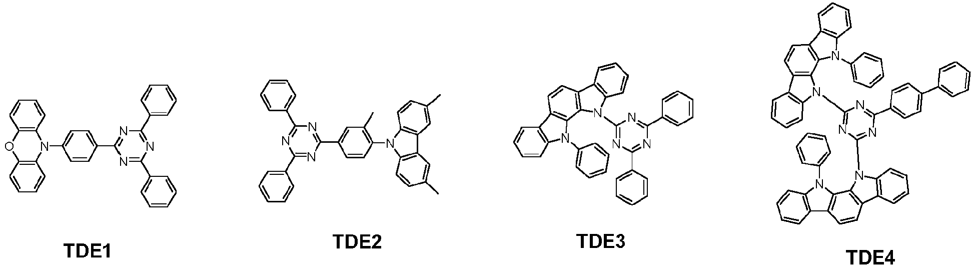

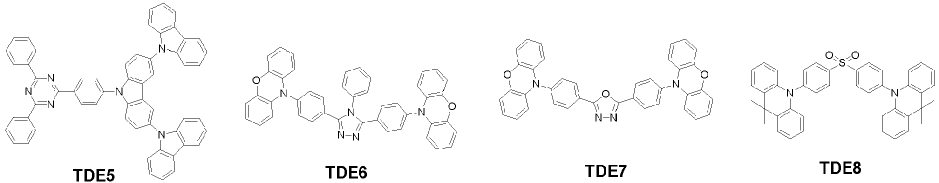

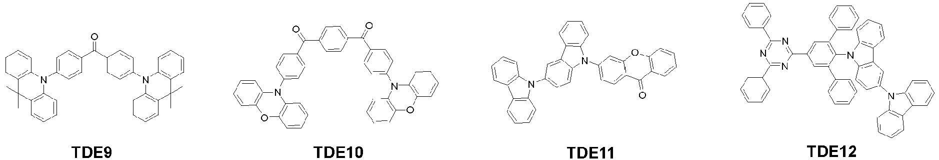

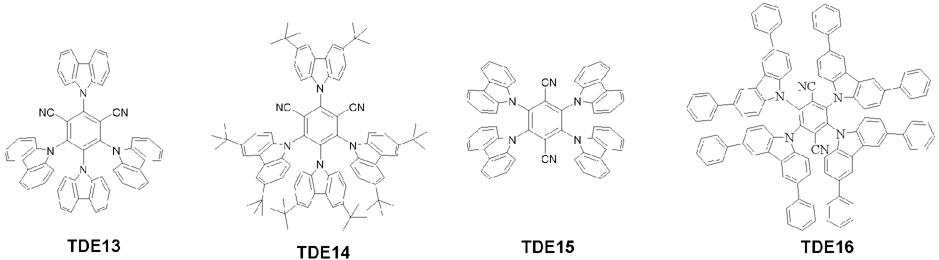

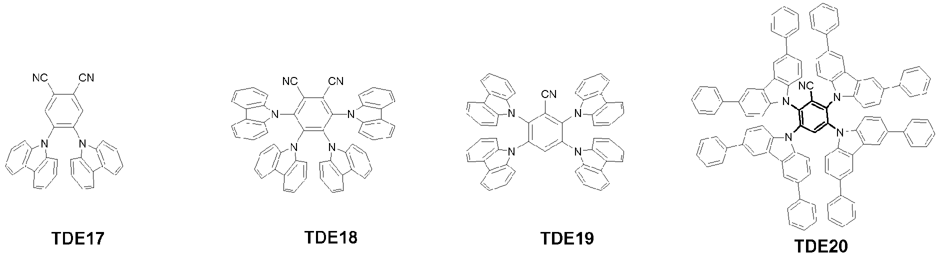

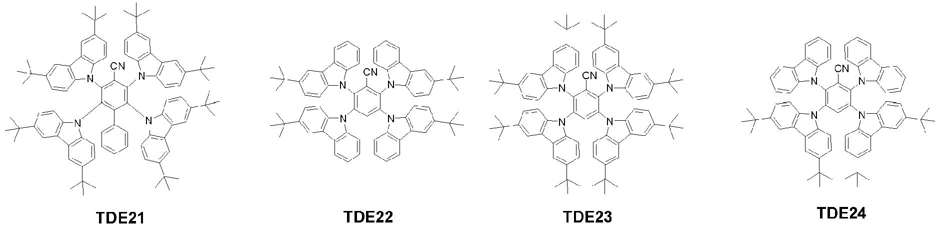

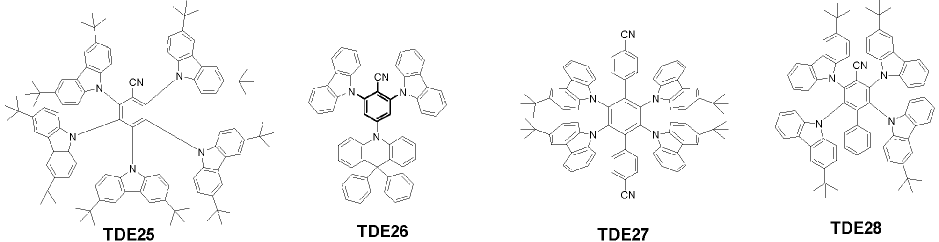

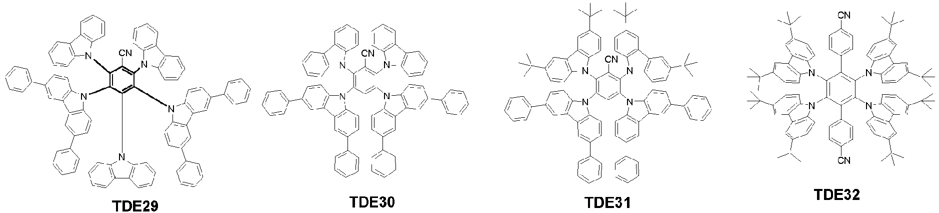

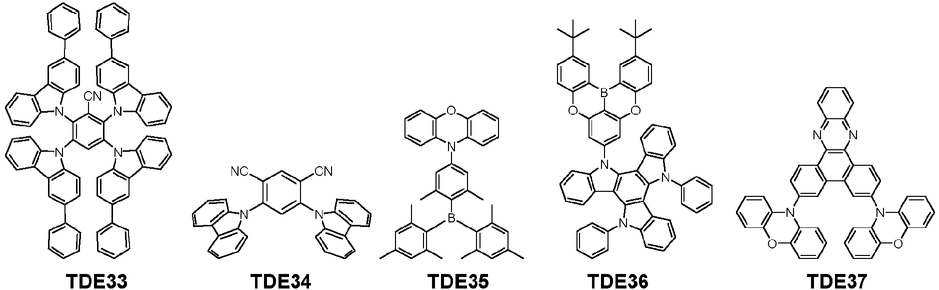

6. The organic electroluminescent device according to any one of claims 1 to 5, wherein a mass of the fluorescent dye accounts for 0.1% to 10% of a total mass of the EMI,.

7. The organic electroluminescent device according to any one of claims 1 to 6, wherein the organic layer further comprises any one or a combination of at least two of a hole injection layer, HIL, a hole transport layer, HTL, a hole blocking layer, HBL, an electron blocking layer, EBL, an electron transport layer, ETL or an electron injection layer, EIL.

8. A display apparatus, comprising the organic electroluminescent device according to any one of claims 1 to 7.

## Patentansprüche

1. Organische elektrolumineszente Vorrichtung, umfassend eine erste Elektrode, eine zweite Elektrode und eine zwischen der ersten Elektrode und der zweiten Elektrode angeordnete organische Schicht,
wobei die organische Schicht eine Emissionsschicht, EML, umfasst, die EML ein Wirtsmaterial, einen Sensibilisator für thermisch aktivierte verzögerte Fluoreszenz, TADF, und einen Fluoreszenzfarbstoff umfasst und der Fluoreszenzfarbstoff aus einer Verbindung ausgewählt ist, die durch Formel (1) dargestellt ist: 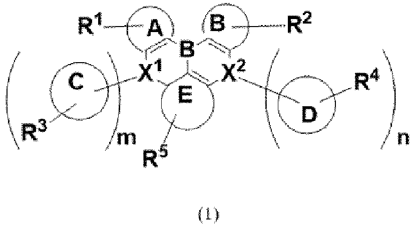 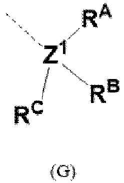
wobei in Formel (1):
die Ringe A, B, C, D und E jeweils unabhängig voneinander einen aromatischen Ring oder einen heteroaromatischen Ring darstellen und zwei benachbarte Ringe in der Lage sind, miteinander zu kondensieren, um einen fünfgliedrigen Ring oder einen sechsgliedrigen Ring zu bilden, der X¹ oder X² enthält;
X¹ und X² jeweils unabhängig voneinander aus O, S, N, C oder Si ausgewählt sind;
m 0, 1 oder 2 ist und n 0, 1 oder 2 ist;
R¹, R², R³, R⁴ und R⁵ jeweils unabhängig voneinander für eine Substitution von einfach bis zur maximal zulässigen Substitution vorliegen und jeweils unabhängig voneinander aus einem oder einer Kombination von mindestens zwei der folgenden Stoffe ausgewählt sind: Wasserstoff, C₁- bis C₁₀-Kettenalkyl, C₃- bis C₁₀-Cycloalkyl, C₁- bis C₁₀-Alkoxy, Halogen, Cyano, Nitro, Hydroxyl, Ester, Silicyl, Amino, substituiertes oder unsubstituiertes C₆- bis C₃₀ -Arylamino, substituiertes oder unsubstituiertes C₃- bis C₃₀ -Heteroarylamino, substituiertes oder unsubstituiertes C₆- bis C₃₀-Aryl oder substituiertes oder unsubstituiertes C₃- bis C₃₀-Heteroaryl und mindestens einer der Reste R¹, R², R³, R⁴ und R⁵ die Formel (G) aufweist, wobei in Formel (G):
Z¹ aus C oder Si ausgewählt ist;
R^{A}, R^{B} und R^{C} jeweils unabhängig voneinander aus einem von C₁- bis C₁₀-Kettenalkyl, C₃- bis C₁₀-Cycloalkyl, substituiertem oder unsubstituiertem C₆- bis C₃₀-Aryl oder substituiertem oder unsubstituiertem C₃- bis C₃₀-Heteroaryl ausgewählt sind, wobei mindestens einer der Reste R^{A}, R^{B} oder R^{C} ein substituiertes oder unsubstituiertes C₆- bis C₃₀-Aryl oder ein substituiertes oder unsubstituiertes C₃- bis C₃₀-Heteroaryl ist und mindestens eines von R^{A}, R^{B} oder R^{C} ein C₁- bis C₁₀-Kettenalkyl oder ein C₃- bis C₁₀-Cycloalkyl ist, und
wenn in R^{A}, R^{B} und R^{C} ein Substituent vorhanden ist, der Substituent aus einem oder einer Kombination von mindestens zwei der folgenden Stoffe ausgewählt ist: Halogen, Cyano, Carboxy, C₁- bis C₁₂-Alkyl, C₃- bis C₁₂-Cycloalkyl, C₂- bis C₁₀-Alkenyl, C₁- bis C₆ -Alkoxy oder Thioalkoxy, C₆-bis C₃₀-monozyklisches Aryl oder Aryl mit kondensierten Ringen oder
C₃- bis C₃₀ -monozyklisches Heteroaryl oder Heteroaryl mit kondensierten Ringen,
**dadurch gekennzeichnet, dass**
der Fluoreszenzfarbstoff aus einer beliebigen oder einer Kombination von mindestens zwei der durch die folgenden Formeln (IV), (V), (VI), (VII) oder (VIII) dargestellten Verbindungen ausgewählt ist: 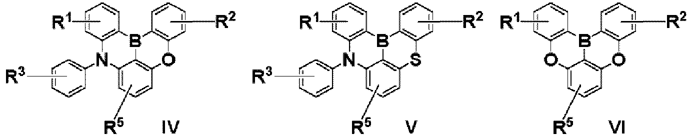 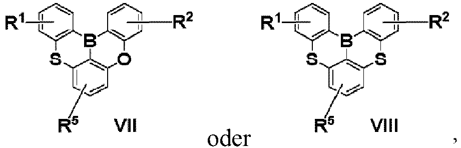
wobei R¹, R², R³ und R⁵ wie in der allgemeinen Formel (1) definiert sind.

2. Organische elektrolumineszente Vorrichtung nach Anspruch 1, wobei die Formel (G) die folgende Formel (G1) ist: 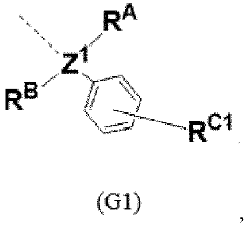 wobei in Formel (G1):
mindestens einer der Reste R^{A} oder R^{B} ein C₁- bis C₁₀-Kettenalkyl oder ein C₃- bis C₁₀-Cycloalkyl ist und
R^{C1} ausgewählt ist aus Wasserstoff, C₁- bis C₁₀-Kettenalkyl, C₃- bis C₁₀-Cycloalkyl, C₁- bis C₁₀-Alkoxy, substituiertem oder unsubstituiertem C₆- bis C₃₀-Arylamino, substituiertem oder
unsubstituiertem C₃- bis C₃₀-Heteroarylamino, substituiertem oder unsubstituiertem C₆- bis C₃₀-Aryl oder substituiertem oder unsubstituiertem C₃- bis C₃₀-Heteroaryl.

3. Organische elektrolumineszente Vorrichtung nach einem der Ansprüche 1 bis 2, wobei die Formel (G) eine der folgenden Formeln a, b, c oder d ist: 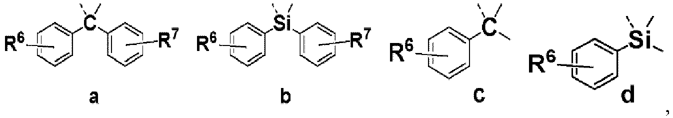 wobei R⁶ und R⁷ jeweils unabhängig voneinander aus einem oder einer Kombination von mindestens zwei der folgenden Stoffe ausgewählt sind: Wasserstoff, Deuterium, Halogen, C₁ -bis C₁₀-Kettenalkyl oder C₃- bis C₁₀-Cycloalkyl.

4. Organische elektrolumineszente Vorrichtung nach einem der Ansprüche 1 bis 3, wobei das Wirtsmaterial aus einer beliebigen oder einer Kombination von mindestens zwei der folgenden Verbindungen TDH-1 bis TDH-30 ausgewählt ist:

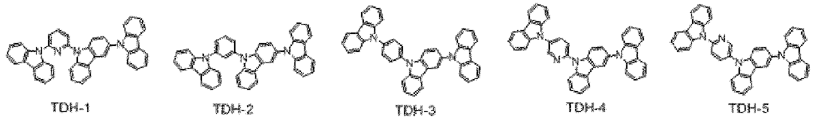

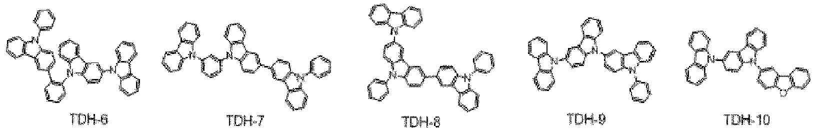

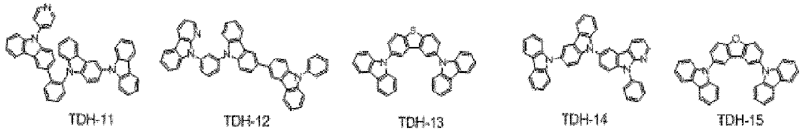

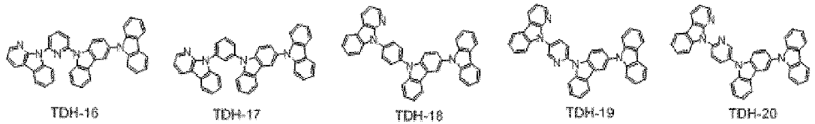

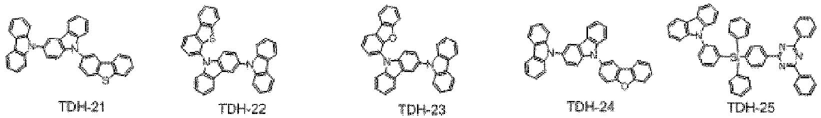

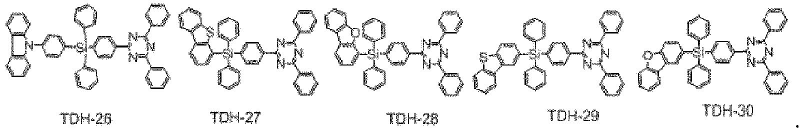

5. Organische elektrolumineszente Vorrichtung nach einem der Ansprüche 1 bis 4, wobei der TADF-Sensibilisator aus einer beliebigen oder einer Kombination von mindestens zwei der folgenden Verbindungen TDE1 bis TDE37 ausgewählt ist:

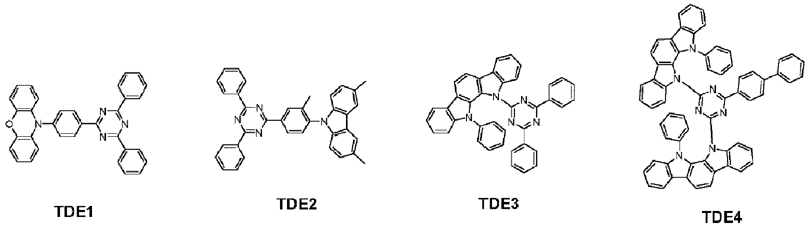

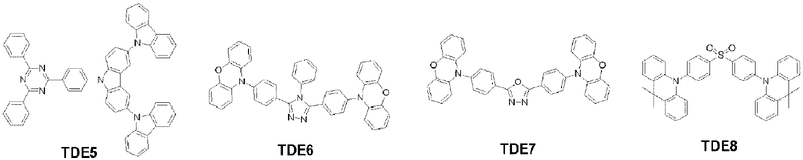

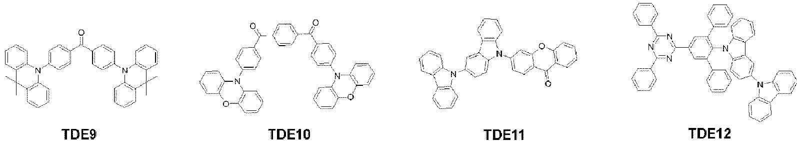

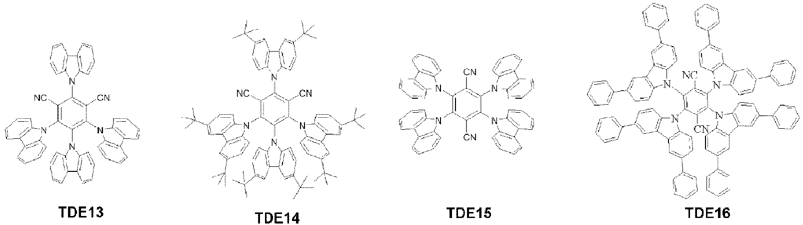

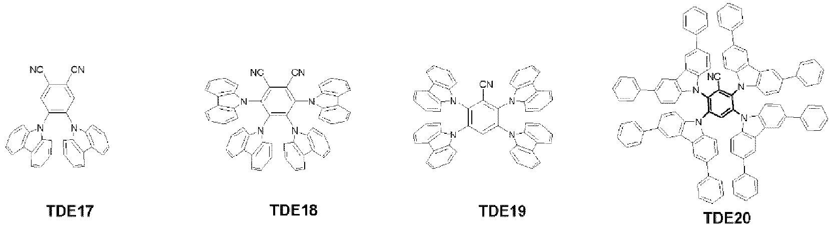

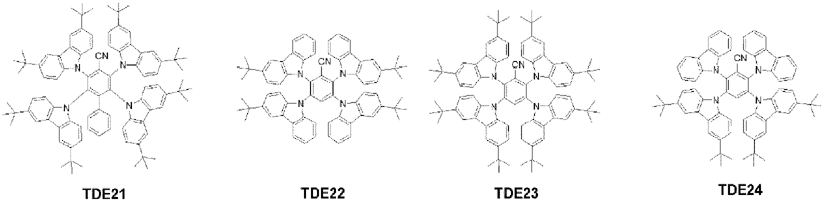

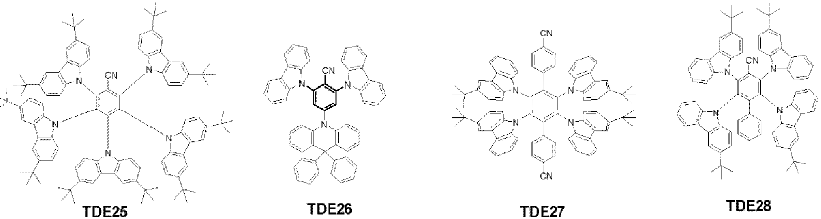

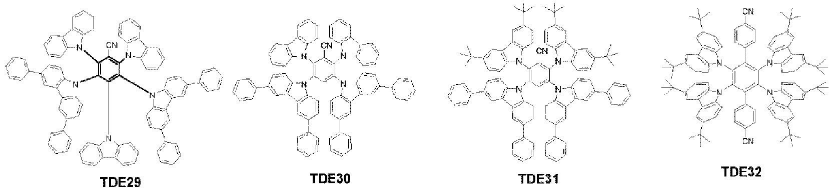

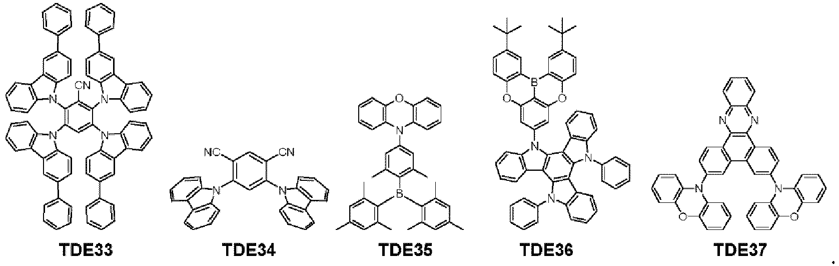

6. Organische elektrolumineszente Vorrichtung nach einem der Ansprüche 1 bis 5, wobei die Masse des Fluoreszenzfarbstoffs 0,1 % bis 10 % der Gesamtmasse der EML ausmacht.

7. Organische elektrolumineszente Vorrichtung nach einem der Ansprüche 1 bis 6, wobei die organische Schicht ferner eine oder eine Kombination aus mindestens zwei der folgenden Schichten umfasst: eine Lochinjektionsschicht, HIL, eine Lochtransportschicht, HTL, eine Lochsperrschicht, HBL, eine Elektronensperrschicht, EBL, eine Elektronentransportschicht, ETL, oder eine Elektroneninjektionsschicht, EIL.

8. Anzeigevorrichtung, umfassend die organische elektrolumineszente Vorrichtung nach einem der Ansprüche 1 bis 7.

## Revendications

1. Dispositif électroluminescent organique, comprenant une première électrode, une seconde électrode et une couche organique disposée entre la première électrode et la seconde électrode,
la couche organique comprend une couche d'émission EML, l'EML comprend un matériau hôte, un sensibilisateur à fluorescence retardée activée thermiquement TADF et un colorant fluorescent, et le colorant fluorescent est choisi parmi un composé représenté par la formule (1) : 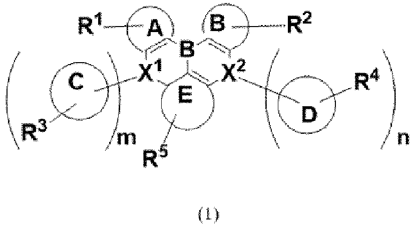 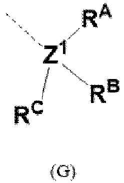
dans lequel, dans la formule (1) :
les cycles A, B, C, D et E représentent chacun indépendamment un cycle aromatique ou un cycle hétéroaromatique, et deux cycles adjacents peuvent être condensés pour former un cycle à cinq chaînons ou un cycle à six chaînons contenant X¹ ou X² ;
X¹ et X² sont chacun choisis indépendamment parmi O, S, N, C ou Si ;
m vaut 0, 1 ou 2, et n vaut 0, 1 ou 2 ;
R¹, R², R³, R⁴ et R⁵ représentent chacun indépendamment une substitution allant d'une mono-substitution à la substitution maximale admissible et sont choisis chacun indépendamment parmi un ou une combinaison d'au moins deux des groupes suivants : hydrogène, alkyle à chaîne en C₁ à C₁₀, cycloalkyle en C₃ à C₁₀, alcoxy en C₁ à C₁₀, halogène, cyano, nitro, hydroxyle, ester, silicyle, amino, arylamino en C₆ à C₃₀ substitué ou non substitué, hétéroarylamino en C₃ à C₃₀ substitué ou non substitué, aryle en C₆ à C₃₀ substitué ou non substitué ou hétéroaryle en C₃ à C₃₀ substitué ou non substitué, et au moins l'un de R¹, R², R³, R⁴ et R⁵ répondant à la formule (G) ;
dans lequel, dans la formule (G) :
Z¹ est choisi parmi C ou Si ;
R^{A}, R^{B} et R^{C} sont choisis chacun indépendamment parmi les groupes suivants : alkyle à chaîne en C₁ à C₁₀, cycloalkyle en C₃ à C₁₀, aryle en C₆ à C₃₀ substitué ou non substitué, ou hétéroaryle en C₃ à C₃₀ substitué ou non substitué, au moins l'un de R^{A}, R^{B} ou R^{C} est un aryle en C₆ à C₃₀, substitué ou non substitué, ou un hétéroaryle en C₃ à C₃₀, substitué ou non substitué, et au moins un de R^{A}, R^{B} ou R^{C} est un alkyle à chaîne en C₁ à C₁₀ ou cycloalkyle en C₃ à C₁₀ ; et
lorsqu'un substituant est présent dans R^{A}, R^{B} et R^{C}, le substituant est choisi parmi un ou une combinaison d'au moins deux des groupes suivants : halogène, cyano, carboxy, alkyle en C₁ à C₁₂, cycloalkyle en C₃ à C₁₂, alcényle en C₂ à C₁₀, alcoxy ou thioalcoxy en C₁ à C₆, aryle monocyclique ou aryle à cycles condensés en C₆ à C₃₀, ou hétéroaryle monocyclique ou
hétéroaryle à cycles condensés en C₃ à C₃₀ ;
**caractérisé en ce que**
le colorant fluorescent est choisi parmi l'un quelconque ou une combinaison d'au moins deux des composés représentés par les formules (IV), (V), (VI), (VII) ou (VIII) suivantes : 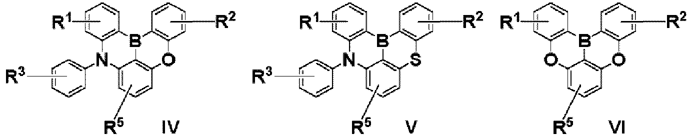 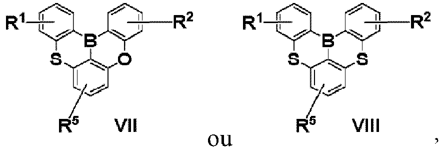
dans lequel R¹, R², R³ et R⁵ sont tels que définis dans la formule générale (1).

2. Dispositif électroluminescent organique selon la revendication 1, dans lequel la formule (G) est la formule (G1) suivante : 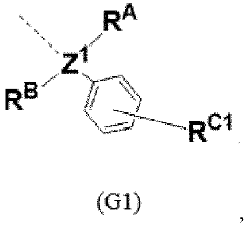 dans lequel, dans la formule (G1) :
au moins un de R^{A} ou R^{B} est un alkyle à chaîne en C₁ à C₁₀ ou un cycloalkyle en C₃ à C₁₀ ; et
R^{C1} est choisi parmi les groupes : hydrogène, alkyle à chaîne en C₁ à C₁₀, cycloalkyle en C₃ à C₁₀, alcoxy en C₁ à C₁₀, arylamino en C₆ à C₃₀ substitué ou non substitué, hétéroarylamino en C₃ à C₃₀ substitué ou non substitué, aryle en C₆ à C₃₀ ou hétéroaryle en C₃ à C₃₀ substitué ou non substitué.

3. Dispositif électroluminescent organique selon l'une quelconque des revendications 1 à 2, dans lequel la formule (G) est l'une des formules a, b, c ou d suivantes : 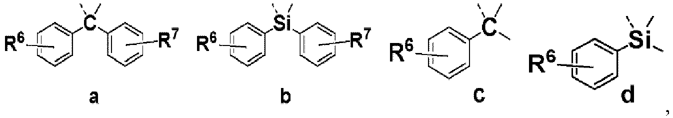 dans lequel R⁶ et R⁷ sont chacun choisis indépendamment parmi un ou une combinaison d'au moins deux des groupes suivants : hydrogène, deutérium, halogène, alkyle à chaîne en C₁ à C₁₀ ou cycloalkyle en C₃ à C₁₀.

4. Dispositif électroluminescent organique selon l'une quelconque des revendications 1 à 3, dans lequel le matériau hôte est choisi parmi l'un quelconque ou une combinaison d'au moins deux des composés suivants TDH-1 à TDH-30 :

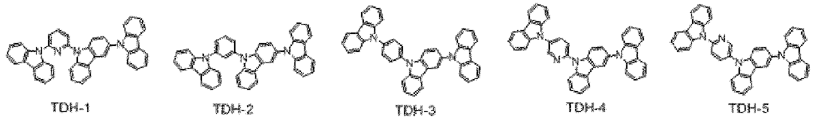

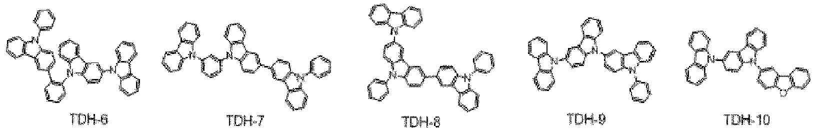

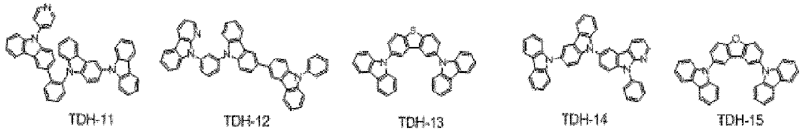

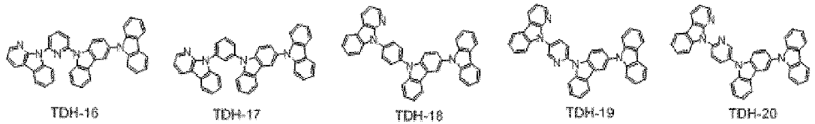

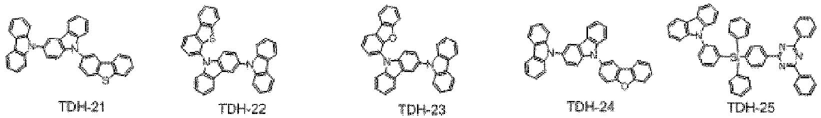

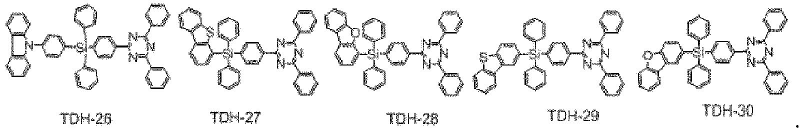

5. Dispositif électroluminescent organique selon l'une quelconque des revendications 1 à 4, dans lequel le sensibilisateur TADF est choisi parmi l'un quelconque ou une combinaison d'au moins deux des composés suivants TDE1 à TDE37 :

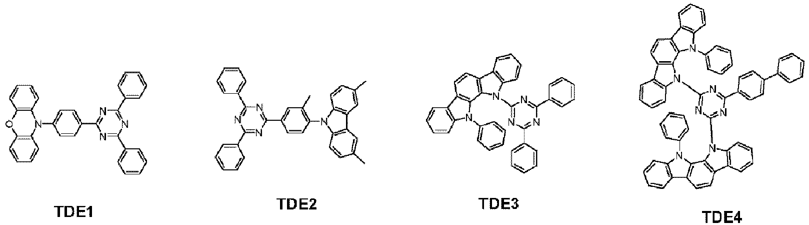

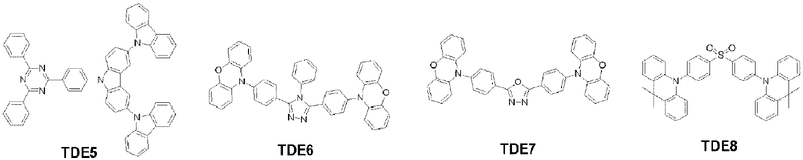

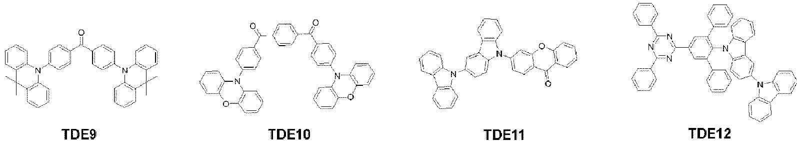

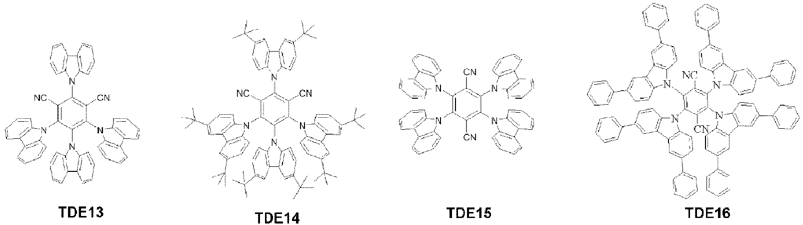

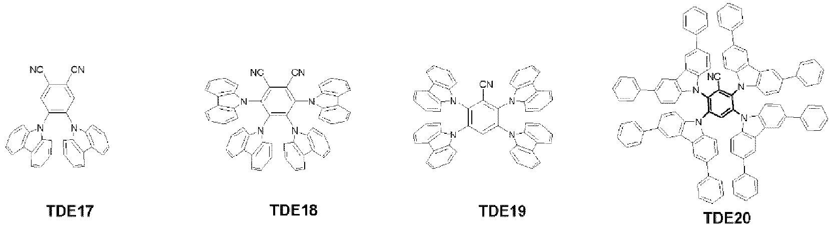

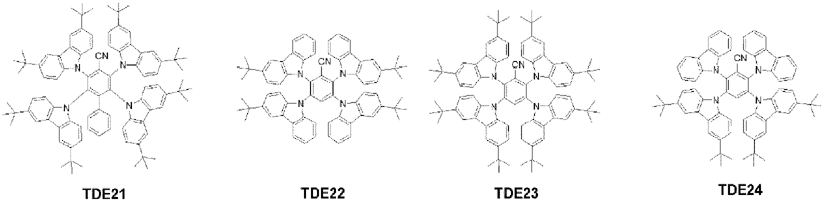

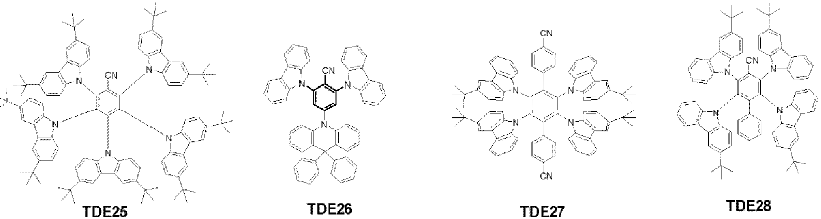

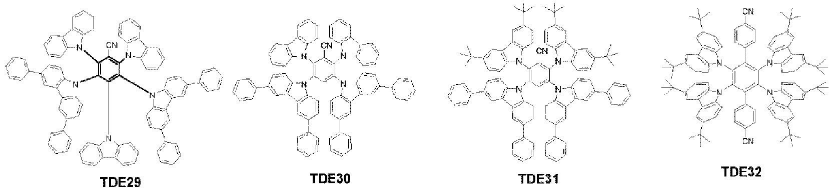

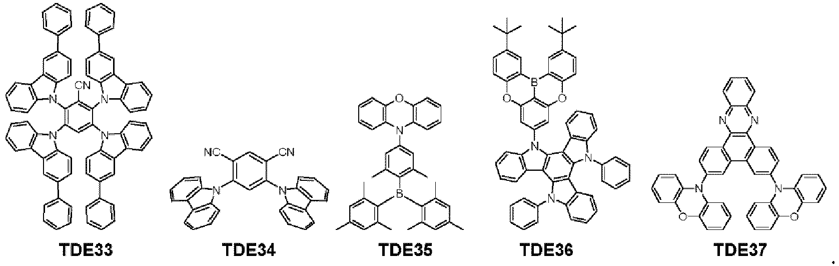

6. Dispositif électroluminescent organique selon l'une quelconque des revendications 1 à 5, dans lequel la masse du colorant fluorescent représente 0,1 % à 10 % de la masse totale de l'EML.

7. Dispositif électroluminescent organique selon l'une quelconque des revendications 1 à 6, dans lequel la couche organique comprend en outre l'un quelconque ou une combinaison d'au moins deux parmi une couche d'injection de trous HIL, une couche de transport de trous HTL, une couche de blocage de trous HBL, une couche de blocage d'électrons EBL, une couche de transport d'électrons ETL ou une couche d'injection d'électrons EIL.

8. Dispositif d'affichage, comprenant le dispositif électroluminescent organique selon l'une quelconque des revendications 1 à 7.
